# EUROPEAN PATENT SPECIFICATION

(11) **EP 4 106 025 B1**
(45) Date of publication and mention of the grant of the patent: **22.04.2026**
(21) Application number: 21180311.9
(22) Date of filing: 18.06.2021
(51) Int. Cl.: H10K 50/15, H10K 50/17, H10K 85/30

(54) **ORGANIC ELECTRONIC DEVICE COMPRISING A COMPOUND OF FORMULA (1), DISPLAY DEVICE COMPRISING THE ORGANIC ELECTRONIC DEVICE AS WELL AS COMPOUNDS OF FORMULA (1) FOR USE IN ORGANIC ELECTRONIC DEVICES**
ORGANISCHE ELEKTRONISCHE VORRICHTUNG MIT EINER VERBINDUNG DER FORMEL (1), ANZEIGEVORRICHTUNG MIT DER ORGANISCHEN ELEKTRONISCHEN VORRICHTUNG SOWIE VERBINDUNGEN DER FORMEL (1) ZUR VERWENDUNG IN ORGANISCHEN ELEKTRONISCHEN VORRICHTUNGEN
DISPOSITIF ÉLECTRONIQUE ORGANIQUE COMPRENANT UN COMPOSÉ DE FORMULE (1), DISPOSITIF D'AFFICHAGE COMPRENANT LE DISPOSITIF ÉLECTRONIQUE ORGANIQUE, AINSI QUE COMPOSÉS DE FORMULE (1) À UTILISER DANS DES DISPOSITIFS ÉLECTRONIQUES ORGANIQUES

(43) Date of publication of application: 21.12.2022
(73) Proprietor: Novaled GmbH, 01099 Dresden (DE)
(72) Inventor: UVAROV, Vladimir, 01099 Dresden (DE); HEGGEMANN, Ulrich, 01099 Dresden (DE); WILLMANN, Steffen, 01099 Dresden (DE)
(74) Representative: Michalski Hüttermann & Partner Patentanwälte mbB

(56) References cited:
- EP-A1- 3 133 663
- EP-A1- 3 133 664
- DE-A1- 102015 121 844
- US-A1- 2018 331 308

## Description

### Technical Field

The present invention relates to an organic electronic device comprising a compound of formula (1) and a display device comprising the organic electronic device. The invention further relates to novel compounds of formula (1) which can be of use in organic electronic devices.

### Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the semiconductor layer, and among them, may be affected by characteristics of metal complexes which are also contained in the semiconductor layer.

There remains a need to improve performance of organic electronic devices by providing hole injection layers with improved performance, in particular to achieve improved operating voltage through improving the characteristics of the hole injection layer and the organic electronic device.

Further there remains a need to provide hole injection layers which enable injection into adjacent layers comprising compounds with a HOMO level further away from vacuum level.

It is a further objective to provide a hole injection layer comprising compounds which can be deposited through vacuum thermal evaporation under conditions suitable for mass production.

Additionally, there is a need to provide compounds with improved thermal properties.

The documents EP 3133663 A1, EP3133664 A1 and US2018/331308 A1 are concerning organic electronic devices comprising in the organic layer a sulfonimide metal complex.

### DISCLOSURE

An aspect of the present invention provides an organic electronic device comprising an anode, a cathode, at least one photoactive layer and at least one semiconductor layer, wherein the at least one semiconductor layer is arranged between the anode and the at least one photoactive layer; and wherein the at least one semiconductor layer comprises
- a compound of Formula (1): 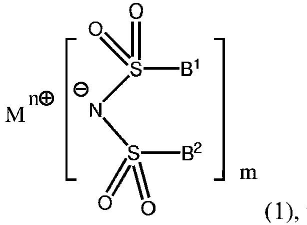 wherein
   M is a metal ion;
   n is the valency of M;
   m is n;
   B¹ is selected from substituted or unsubstituted C₂ to C₂₀ heteroaryl;
   B² is selected from C₁ to C₈ alkyl, substituted or unsubstituted C₆ to C₁₉ aryl, substituted or unsubstituted C₂ to C₂₀ heteroaryl, substituted or unsubstituted C₂ to C₂₀ heterocycle;
   wherein
      the substituents on B¹ and B² are independently selected from D, halogen, Cl, F, CN,
      partially or perfluorinated C₁ to C₈ alkyl, partially or perfluorinated C₁ to C₈ alkoxy; and
- a covalent matrix compound or substantially covalent matrix compound, wherein the calculated HOMO of the covalent matrix compound or substantially covalent matrix compound is in the range of < -4.5 eV and > 6.5 eV.

According to on embodiment the organic electronic device comprises an anode, a cathode, at least one photoactive layer and at least one semiconductor layer, wherein the at least one semiconductor layer is arranged between the anode and the at least one photoactive layer; and wherein the at least one semiconductor layer comprises
- a compound of Formula (1): 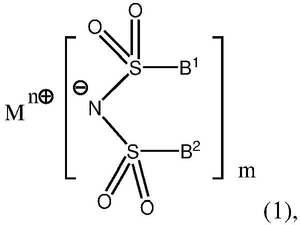 wherein
   M is a metal ion;
   n is the valency of M;
   m is n;
   B¹ is selected from substituted or unsubstituted C₂ to C₂₀ heteroaryl;
   B² is selected from C₁ to C₈ alkyl, substituted or unsubstituted C₆ to C₁₉ aryl, substituted or unsubstituted C₂ to C₂₀ heteroaryl, substituted or unsubstituted C₂ to C₂₀ heterocycle;
   wherein
      the substituents on B¹ and B² are independently selected from D, halogen, Cl, F, CN,
      partially or perfluorinated C₁ to C₈ alkyl, partially or perfluorinated C₁ to C₈ alkoxy; and
- a covalent matrix compound or substantially covalent matrix compound, wherein the calculated HOMO of the covalent matrix compound or substantially covalent matrix compound is in the range of < -4.5 eV and > 6.5 eV, wherein the HOMO is calculated with program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to one embodiment the at least one semiconductor layer can be a hole injection layer, and preferably the at least one semiconductor layer, which can be a hole injection layer, is non-emissive.

The negative charge in compounds of formula (1) may be delocalized partially or fully over the N(SO₂)₂ group and optionally also over the B¹ and/or B² groups.

It should be noted that throughout the application and the claims any Bⁿ ,Rⁿ etc. always refer to the same moieties, unless otherwise noted.

In the present specification, when a definition is not otherwise provided, "substituted" refers to one substituted with a deuterium, also named D, halogen, Cl, F, CN, partially or perfluorinated C₁ to C₈ alkyl, partially or perfluorinated C₁ to C₈ alkoxy.

However, in the present specification "aryl substituted" refers to a substitution with one or more aryl groups, which themselves may be substituted with one or more aryl and/or heteroaryl groups.

Further the term "substituted or unsubstituted aryl" or "substituted or unsubstituted C₆ to C₁₉ aryl" are includes aryl compounds of "fused aryl rings" or "condensed aryl rings".

Correspondingly, in the present specification "heteroaryl substituted" refers to a substitution with one or more heteroaryl groups, which themselves may be substituted with one or more aryl and/or heteroaryl groups.

Further the term "substituted or unsubstituted heteroaryl" or "substituted or unsubstituted C₂ to C₂₀ heteroaryl" are includes heteroaryl compounds of "fused heteroaryl rings" or "condensed aryl rings" or "fused heteroaryl rings comprising at least one non-heteroaryl ring" or "condensed aryl rings comprising at least one non-heteroaryl ring".

The term "fused aryl rings" or "condensed aryl rings" is understood the way that two aryl rings are considered fused or condensed when they share at least two common sp²-hybridized carbon atoms.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group. The alkyl group may be a C₁ to C₁₂ alkyl group or C₁ to C₈ alkyl group. More specifically, the alkyl group may be a C₁ to C₁₀ alkyl group or a C₁ to C₆ alkyl group. For example, a C₁ to C₄ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an iso-propyl group, a butyl group, an iso-butyl group, a tert-butyl group, a pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methyl cyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S, and most preferred N.

The term "fused ring system" is understood to mean a ring system wherein two or more rings share at least two atoms.

The term "5-, 6- or 7-member ring" is understood to mean a ring comprising 5, 6 or 7 atoms. The atoms may be selected from C and one or more hetero-atoms.

In the present specification, the single bond refers to a direct bond.

In the context of the present invention, "different" means that the compounds do not have an identical chemical structure.

The term "free of", "does not contain", "does not comprise" does not exclude impurities which may be present in the compounds prior to deposition. Impurities have no technical effect with respect to the object achieved by the present invention.

The term "contacts" or "contacting" refers to an arrangement of at least two layers whereby a first layer is in direct contact with an adjacent second layer.

The term "photoactive layer" may comprise "light-absorbing layer" and "light absorption layer" are used synonymously.

The term "photoactive layer" may comprise layer such as "light-emitting layer", "light emission layer" and "emission layer".

The terms "OLED", "organic light-emitting diode" and "organic light-emitting device" are used synonymously.

The terms anode and anode electrode are used synonymously. The term "at least two anode sub-layers" is understood to mean two or more anode sub-layers, for example two or three anode sub-layers.

The terms cathode and cathode electrode are used synonymously.

The term "hole transport layer" is understood to mean a layer which transports holes between the hole injection layer and further layers arranged between the hole injection layer and the cathode layer.

The operating voltage U is measured in Volt.

In the context of the present specification the term "essentially non-emissive" or "non-emissive" means that the contribution of compound of Formula (1), covalent matrix compound, substantially covalent matrix compound, matrix compound of formula (2) or formula (3), metal complex and/or layer, such as hole injection layer, to the visible emission spectrum from an organic electronic device, such as OLED or display device, is less than 10 %, preferably less than 5 % relative to the visible emission spectrum. The visible emission spectrum is an emission spectrum with a wavelength of about ≥ 380 nm to about ≤ 780 nm.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

The term "HOMO level" is understood to mean the highest occupied molecular orbital and is determined in eV (electron volt).

The term "HOMO level further away from vacuum level" is understood to mean that the absolute value of the HOMO level is higher than the absolute value of the HOMO level of the reference compound. For example, the term "further away from vacuum level than the HOMO level of N2,N2,N2',N2',N7,N7,N7',N7'-octakis(4-methoxyphenyl)-9,9'-spirobi[fluorene]-2,2',7,7'-tetraamine is understood to mean that the absolute value of the HOMO level of the covalent matrix compound or substantially covalent matrix compound of the hole injection layer is higher than the HOMO level of N2,N2,N2',N2', N7,N7, N7',N7'-octakis(4-methoxyphenyl)-9,9'-spirobi[fluorene]-2,2',7,7'-tetraamine.

The term "absolute value" is understood to mean the value without the "-" symbol. According to one embodiment of the present invention, the HOMO level of the covalent matrix compound or substantially covalent matrix compound, preferably the matrix compound of the hole injection layer may be calculated by quantum mechanical methods.

The work function of the first metal is measured in eV (electron volt). Tabulated values of work functions can be found for example in CRC Handbook of Chemistry and Physics version 2008, p. 12-114. Further, tabulated values of work functions can be found for example at https://en.wikipedia.org/wiki/Work_function#cite_note-12.

### Advantageous Effects

Surprisingly, it was found that the organic electronic device according to the invention solves the problem underlying the present invention by enabling organic electronic devices, such as organic light-emitting diodes, in various aspects superior over the organic electronic devices known in the art, in particular with respect to operating voltage, efficiency, lifetime and/or voltage stability over time.

Additionally, it was found that the problem underlying the present invention can be solved by providing compounds which may be suitable for deposition from solution and/or vacuum thermal evaporation under conditions suitable for mass production.

### Substituents on B¹ and B²

According to one embodiment of the present invention, the substituents on B¹ and B² are independently selected from the group comprising halogen, wherein the halogen is preferably selected F, C₁ to C₃ perhalogenated, wherein the C₁ to C₃ perhalogenated is preferably perfluorinated, partially or perfluorinated C₁ to C₆ alkoxy, or -(O)₁-C_{q}H_{2q}-CₚHalₚ₂ₚ₊₁ with 1 = 0 or 1, preferably 0, q = 1 or 2, preferably 1 and p = 1 to 3, preferably 1 or 2 and Hal = halogen, preferably F.

According to one embodiment of the present invention, at least one of B¹ and B² is substituted with C₁ to C₈ alkyl or C₁ to C₈ alkoxy and the substituents of the C₁ to C₈ alkyl or C₁ to C₈ alkoxy moiety are fluorine with the number n_{F} (of fluorine substituents) and n_{H} (of hydrogens) follow the equation: n_{F} > n_{H} + 2.

According to one embodiment of the present invention, at least one of B¹ and B² is substituted with perfluorinated C₁ to C₈ alkyl or perfluorinated C₁ to C₈ alkoxy.

According to one embodiment of the present invention, at least one of B¹ and B² is substituted with partially or perfluorinated C₃ to C₆ alkyl.

According to one embodiment B¹ is a substituted or unsubstituted heteroaryl 6-member ring with at least 3 N atoms, at least 2 N atoms or at least 1 N atom and the remaining atoms are C. According to one embodiment B¹ is a substituted or unsubstituted heteroaryl 6-member ring with at least 2 N atoms and the remaining atoms are C. According to one embodiment B¹ is a substituted or unsubstituted heteroaryl 6-member ring with at least 1 N atoms and the remaining atoms are C.

According to one embodiment B¹ is a mono-substituted heteroaryl 6-member ring with at least 3 N atoms and the remaining atoms are C. wherein the substituent is CF₃ or CN. According to one embodiment B¹ is a mono-substituted heteroaryl 6-member ring with at least 2 N atoms and the remaining atoms are C, wherein the substituent is CF₃ or CN. According to one embodiment B¹ is a mono-substituted heteroaryl 6-member ring with at least 1 N atoms and the remaining atoms are C, wherein the substituent is CF₃ or CN.

According to one embodiment B¹ is a di-substituted heteroaryl 6-member ring with at least 3 N atoms and the remaining atoms are C. wherein the substituent is CF₃ or CN. According to one embodiment B¹ is a di-substituted heteroaryl 6-member ring with at least 2 N atoms and the remaining atoms are C, wherein the substituent is CF₃ or CN. According to one embodiment B¹ is a di-substituted heteroaryl 6-member ring with at least 1 N atoms and the remaining atoms are C, wherein the substituent is CF₃ or CN.

Preferably B¹ is a substituted or unsubstituted heteroaryl 6-member ring with one N atom and the remaining atoms are C substituted with one or two substituents selected from CF₃ or CN.

According to one embodiment B¹ is selected from the group comprising substituted or unsubstituted pyridyl or substituted or unsubstituted 3-pyridyl.

According to one embodiment B² is substituted C₆-aryl, a substituted heteroaryl 6-member ring with one N atoms or a substituted heteroaryl of a 5-member ring with one or two heteroatoms selected from N or S, preferably N, and the remaining atoms are C, wherein the substituent is CF₃ or CN.

According to one embodiment B² is selected from the group of perfluorinated C₁ to C₆ alkyl, CF₃, C₂F₅, C₃F₇ or C₄F₉.

According to one embodiment B² is selected from tetra or penta fluorinated C₆-aryl or persubstituted C₆-aryl, wherein 4 substituents are F and one substituent is selected CF₃, C₂F₅, C₃F₇ or C₄F₉, preferably CF₃.

According to one embodiment B² is selected from persubstituted C₆-aryl, wherein 4 substituents are F and one is CN.

According to one embodiment B² is selected from mono-substituted heteroaryl of a 5-member ring with two hetero atoms of N or N and S, wherein the substituent is CN or CF₃, preferably CF₃.

According to one embodiment B² is selected from di- substituted heteroaryl of a 5-member ring with two hetero atoms of N, or N and S, wherein the substituents are CN or CF₃, preferably CF₃.

Preferably B¹ is a substituted or unsubstituted heteroaryl 6-member ring with one N atom and the remaining atoms are C substituted with one or two substituents selected from F, CF₃ or CN, preferably CF₃ or CN; and B² is a substituted C₆-aryl, a substituted heteroaryl 5- or 6-member ring with one or two heteroatoms selected from N or S, preferably N, and the remaining atoms are C, wherein the substituent is F, CF₃ or CN, preferably CF₃ or CN, further B² is a perfluorinated C₁ to C₆ alkyl, CF₃, C₂F₅, C₃F₇ or C₄F₉, or B² is selected from tetra or penta fluorinated C₆-aryl or persubstituted C₆-aryl, wherein 4 substituents are F and one substituent is selected CF₃, C₂F₅, C₃F₇ or C₄F₉, preferably CF₃.

According to one embodiment of the present invention B² is phenyl or six-membered heteroaryl, which is substituted with 1 to 5 F atoms.

According to one embodiment, the anion of compound of formula (1) is selected from the anions A1 to A71:

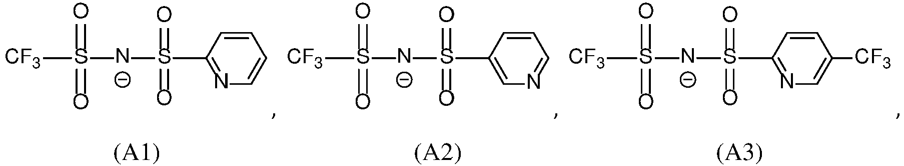

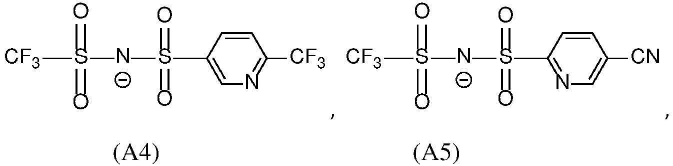

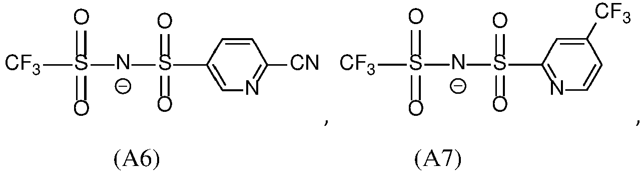

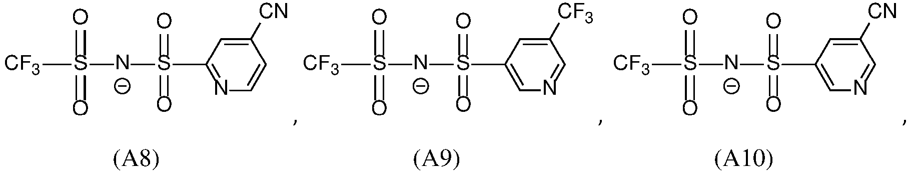

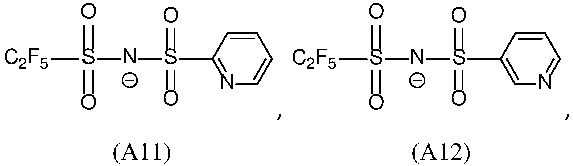

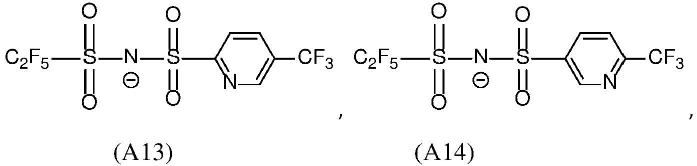

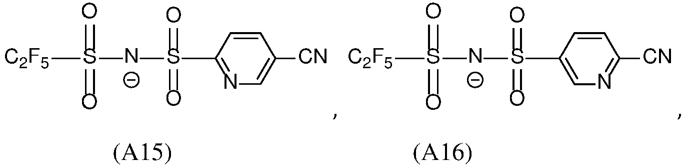

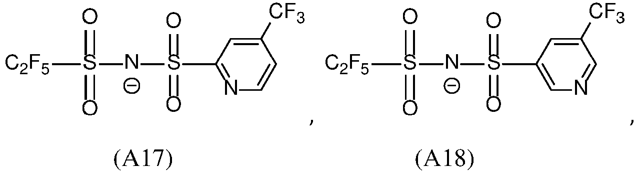

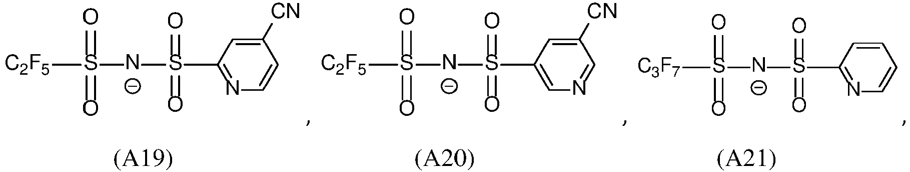

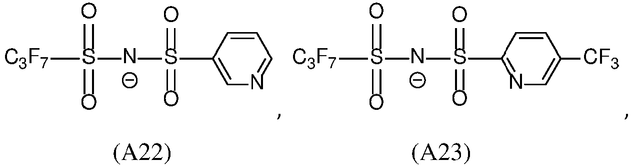

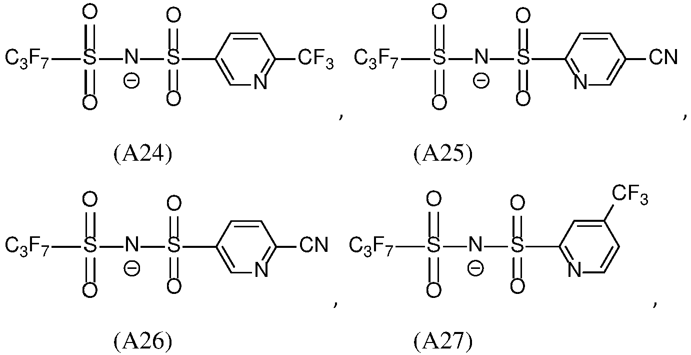

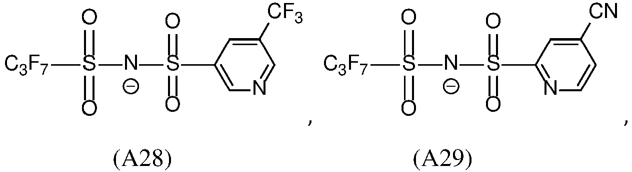

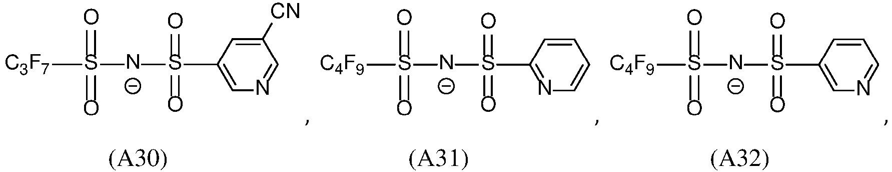

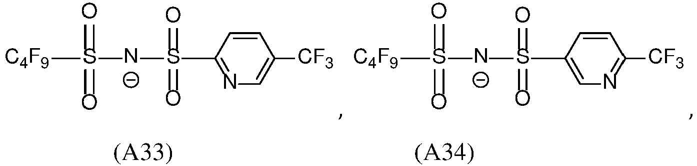

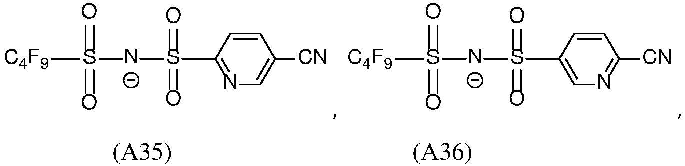

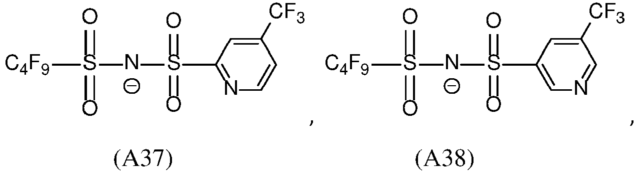

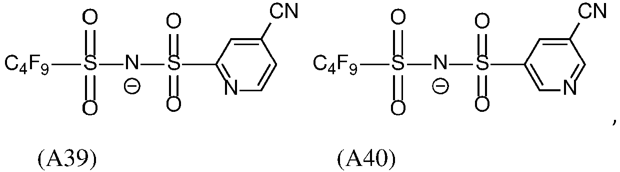

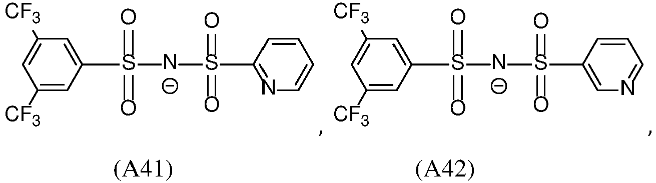

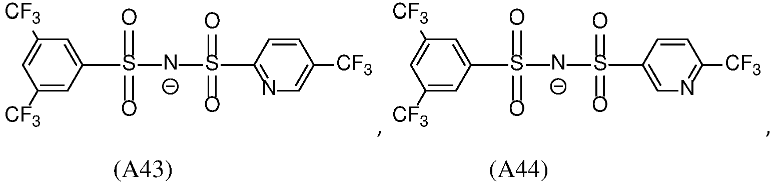

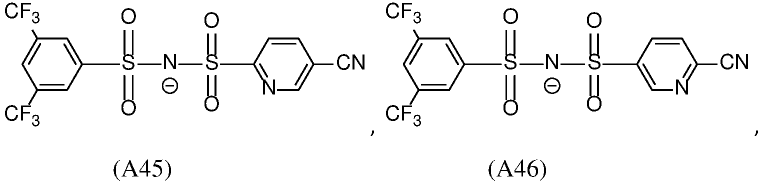

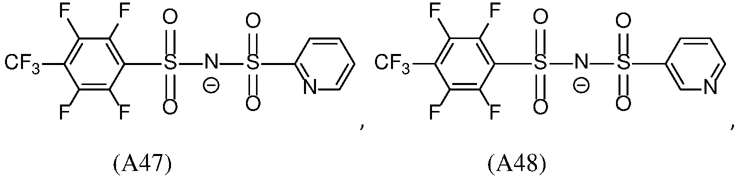

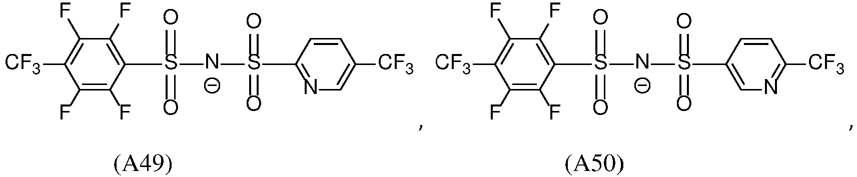

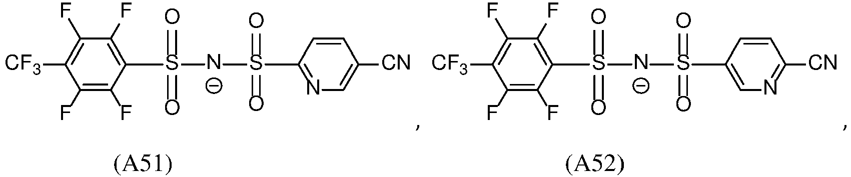

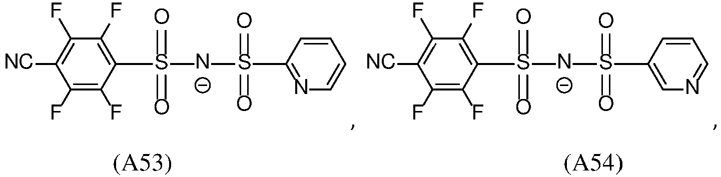

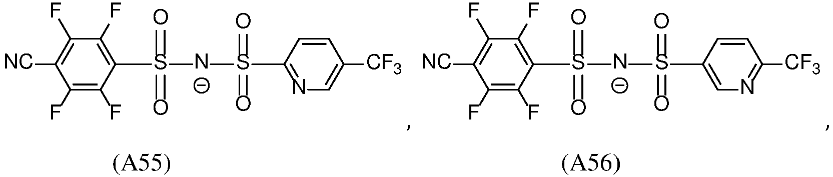

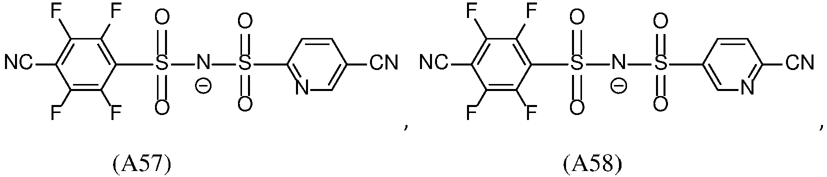

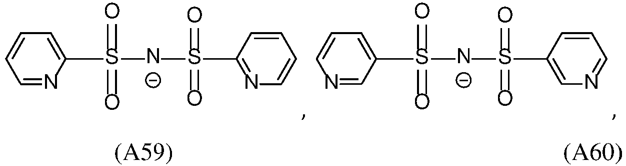

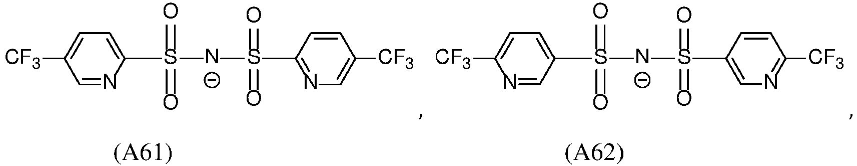

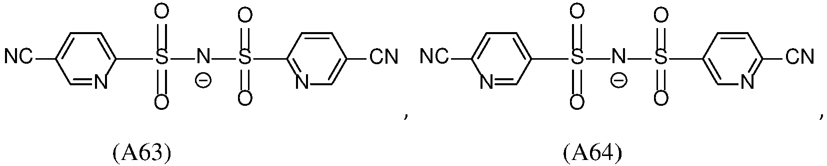

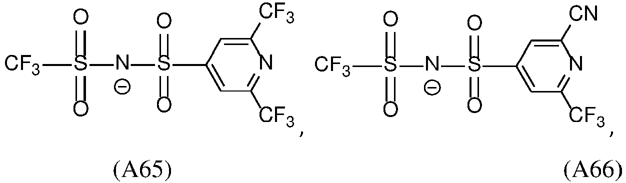

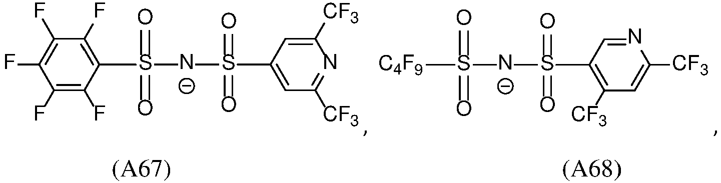

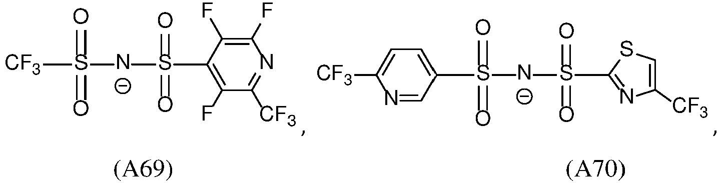

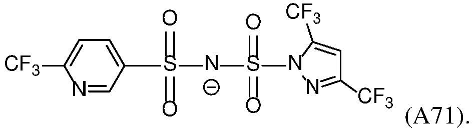

### M of the metal complex of formula (1)

The metal complex according to formula (1) is non-emissive. In the context of the present specification the term "essentially non-emissive" or "non-emissive" means that the contribution of the metal complex according to formula (1) to the visible emission spectrum from an organic electronic device, such as OLED or display device, is less than 10 %, preferably less than 5 % relative to the visible emission spectrum. The visible emission spectrum is an emission spectrum with a wavelength of about ≥ 380 nm to about ≤ 780 nm.

According to one embodiment of the present invention, the valency n of M of the metal complex according to formula (1) is 1,2, 3 or 4; preferably 1, 2 or 3; more preferred 1 or 2.

According to one embodiment of the present invention, M has an atomic mass of ≥ 22Da, alternatively ≥ 24Da.

According to one embodiment of the present invention, M is selected from a metal ion wherein the corresponding metal has an electronegativity value according to Allen of less than 2.4, preferably less than 2, more preferred less than 1.9. Thereby, particularly good performance in organic electronic devices may be achievable.

The term "electronegativity according to Allen" especially refers to Allen, Leland C.

(1989). "Electronegativity is the average one-electron energy of the valence-shell electrons in ground-state free atoms". Journal of the American Chemical Society. 111 (25): 9003-9014.

According to one embodiment of the present invention the valency n of M is 1 or 2.

According to one embodiment of the present invention, M is selected from a metal ion wherein the corresponding metal has an electronegativity value according to Allen of less than 2.4, preferably less than 2, more preferred less than 1.9, and the valency n of M is 1 or 2.

According to one embodiment of the present invention, M is selected from an alkali, alkaline earth, rare earth or transition metal, alternatively M is selected from alkali, alkaline earth, or a period 4 or 5 transition metal.

According to one embodiment of the present invention, M is selected from a metal ion wherein the corresponding metal has an electronegativity value according to Allen of less than 2.4, preferably less than 2, more preferred less than 1.9 and M is selected from alkali, alkaline earth, rare earth or a period 4 or 5 transition metal and M has an atomic mass of ≥ 22Da, alternatively ≥ 24Da.

According to one embodiment of the present invention, M is selected from an alkaline earth metal, transition metal or rare earth metal, preferably Cu(II), Ag(I), Zn(II), Fe(II), Fe(III), Mg(II), and more preferred Cu(II), Ag(I), Zn(II) or Fe(II).

According to one embodiment of the present invention, M is selected from Li, Na, K, Cs, Mg, Mn, Cu, Zn, Ag and Mo; preferably M is selected from Na, K, Cs, Mg, Mn, Cu, Zn and Ag; also preferred M is selected from Na, K, Mg, Mn, Cu, Zn and Ag, wherein if M is Cu, n is 2.

According to one embodiment of the present invention, M is not Ag.

According to one embodiment of the present invention, M is not Cu.

According to one embodiment of the present invention the compound of formula (1) is selected from the compounds D1 to D8:

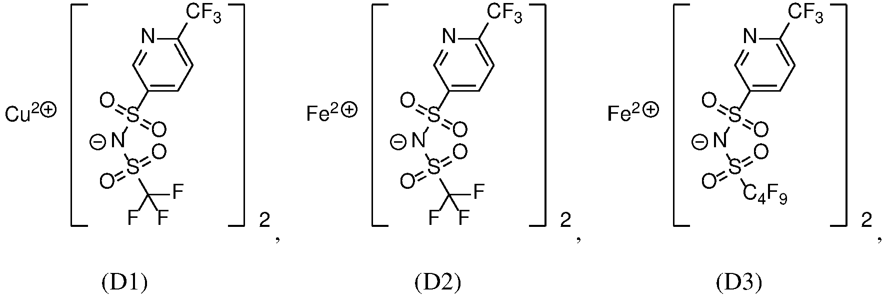

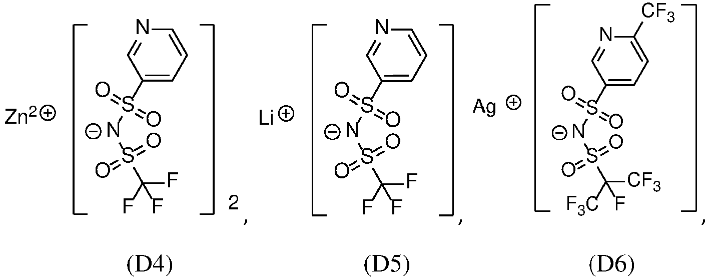

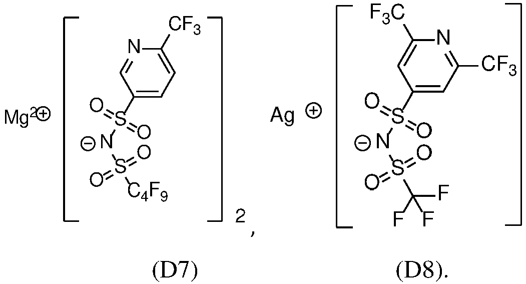

According to one embodiment of the present invention the at least one semiconductor layer comprising the compound of formula (1) is an organic semiconductor layer, and preferably the at least one semiconductor layer is non-emissive.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

According to one embodiment of the invention, at least one semiconductor layer is arranged and/or provided adjacent to the anode.

According to one embodiment of the invention, at least one semiconductor layer is in direct contact with the anode.

According to one embodiment of the invention, wherein the at least one semiconductor layer of the present invention is a hole-injection layer.

According to one embodiment of the invention, wherein the at least one of the semiconductor layers is a hole-injection layer, which consists of at least one compound of formula (1) or comprises at least one compound of formula (1).

In case the at least one semiconductor layer of the present invention is a hole-injection layer and/ or is arranged and/or provided adjacent to the anode then it is especially preferred that this layer consists essentially of the compound of formula (1).

In the context of the present specification the term "consisting essentially of " especially means and/or includes a concentration of ≥ 90% (vol/vol) more preferred ≥ 95% (vol/vol) and most preferred ≥ 99% (vol/vol).

According to another aspect, the at least one semiconductor layer may have a layer thickness of at least about ≥ 0.5 nm to about ≤ 10 nm, preferably of about ≥ 2 nm to about ≤ 8 nm, also preferred of about ≥ 3 nm to about ≤ 5 nm.

According to one embodiment of the invention, at least one semiconductor layer of the present invention further comprises a covalent matrix compound or substantially covalent matrix compound. Preferably at least one semiconductor layer further comprising a covalent matrix compound or substantially covalent matrix compound is arranged and/or provided adjacent to the anode.

Preferred examples of covalent matrix compounds are organic compounds, consisting predominantly from covalently bound C, H, O, N, S, which may optionally comprise also covalently bound B, P, As, Se. Organometallic compounds comprising covalent bonds carbon-metal, metal complexes comprising organic ligands and metal salts of organic acids are further examples of organic compounds that may serve as organic covalent matrix compound or substantially covalent matrix compounds.

In one embodiment, the covalent matrix compound or substantially covalent matrix compound lacks metal atoms and majority of its skeletal atoms is selected from C, O, S, N. Alternatively, the covalent matrix compound or substantially covalent matrix compound lacks metal atoms and majority of its skeletal atoms is selected from C and N.

In one embodiment, the HOMO level of the covalent matrix compound or substantially covalent matrix compound may be more negative than the HOMO level of N2,N2,N2',N2',N7,N7,N7',N7'-octakis(4-methoxyphenyl)-9,9'-spirobi[fluorene]-2,2',7,7'-tetraamine (CAS 207739-72-8) when determined under the same conditions.

According to another aspect of the present invention, the semiconductor layer further comprises a covalent matrix compound or substantially covalent matrix compound with an oxidation potential more positive than - 0.2 V and more negative than 1.22 V, when measured by cyclic voltammetry in dichloromethane vs. Fc/Fc+, preferably more positive than - 0.18 V and more negative than 1.12 V. Under these conditions the oxidation potential of spiro-MeO-TAD (CAS 207739-72-8) is -0.07 V.

In one embodiment, the HOMO level of the covalent matrix compound or substantially covalent matrix compound may be more negative than the HOMO level of N2,N2,N2',N2',N7,N7,N7',N7'-octakis(4-methoxyphenyl)-9,9'-spirobi[fluorene]-2,2',7,7'-tetraamine (CAS 207739-72-8) and more positive than the HOMO level of N4,N4‴-di(naphthalen-1-yl)-N4,N4‴-diphenyl-[1,1':4',1":4",1‴-quaterphenyl]-4,4‴-diamine when determined under the same conditions.

In one embodiment of the present invention, the covalent matrix compound or substantially covalent matrix compound may be free of alkoxy, COR¹ and/or COOR¹ groups, and wherein R¹ on COR¹ and/or COOR¹ is selected from aryl, heteroaryl, alkyl, alkoxy, branched alkyl, cyclic alkyl, branched alkoxy, cyclic alkoxy, partially or perfluorinated alkyl, partially or perfluorinated alkoxy, partially or perdeuterated alkyl, partially or perdeuterated alkoxy.

In one embodiment, the calculated HOMO level of the covalent matrix compound or substantially covalent matrix compound may be selected in the range of < -4.6 eV and > -6 eV, alternatively in the range of < -4.65 eV and > -5 eV, alternatively in the range of < -4.67 eV and > -5 eV, alternatively in the range of < -4.67 eV and > -4.85 eV.

According to one embodiment the at least one semiconductor layers further comprises a covalent matrix compound or a substantially covalent matrix compound, preferably the covalent matrix compound or a substantially covalent matrix compound is selected from at least one arylamine compound, a diarylamine compound or a triarylamine compound.

Preferably, the covalent matrix compound or substantially covalent matrix compound comprises at least one arylamine compound, alternatively a diarylamine compound, alternatively a triarylamine compound.

According to an embodiment of the organic electronic device, wherein the covalent matrix compound or substantially covalent matrix compound, preferably of the hole injection layer, may comprises a compound of formula (2) or formula (3): wherein 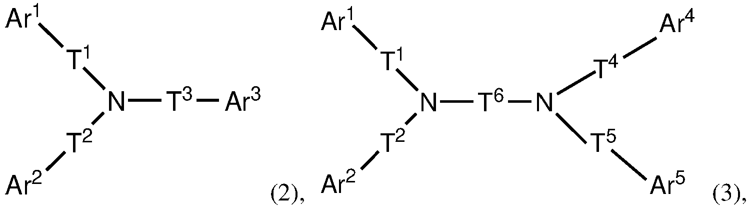
- T¹, T², T³, T⁴ and T⁵: may be independently selected from a single bond, phenylene, biphenylene, terphenylene or naphthenylene, preferably a single bond or phenylene;
- T⁶: is phenylene, biphenylene, terphenylene or naphthenylene;
- Ar¹, Ar², Ar³, Ar⁴ and Ar⁵: may be independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (2) 5- to 6-member of an aromatic heterocycle, (3) unsaturated 5- to 7-member ring of a non-heterocycle, (iv) 6-member ring of an aromatic non-heterocycle;
wherein the substituents of Ar¹, Ar², Ar³, Ar⁴ and Ar⁵ are selected the same or different from the group comprising H, straight-chain alkyl having 1 to 20 carbon atoms, branched alkyl having 1 to 20 carbon atoms, cyclic alkyl having 3 to 20 carbon atoms, alkenyl or alkynyl groups having 2 to 20 carbon atoms, alkoxy groups having 1 to 20 carbon atoms, C₆ to C₁₈ aryl, C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle.

Preferably, the substituents of Ar¹, Ar², Ar³, Ar⁴ and Ar⁵ are selected the same or different from the group comprising H, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, alkoxy groups having 1 to 6 carbon atoms, C₆ to C₁₈ aryl, C₃ to C₁₈ heteroaryl, a fused ring system comprising 2 to 4 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; more preferred the substituents are selected the same or different from the group consisting of H, straight-chain alkyl having 1 to 4 carbon atoms, branched alkyl having 1 to 4 carbon atoms, cyclic alkyl having 3 to 4 carbon atoms and/or phenyl. Thereby, the compound of formula (2) or (3) may have a rate onset temperature suitable for mass production.

According to an embodiment of the organic electronic device, wherein covalent matrix compound or substantially covalent matrix compound, preferably the matrix compound of the hole injection layer, comprises a compound of formula (2) or formula (3): wherein 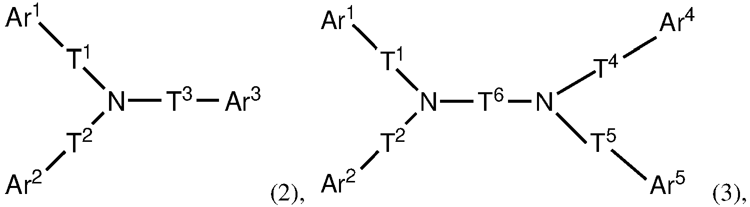
- T¹, T², T³, T⁴ and T⁵: may be independently selected from a single bond, phenylene, biphenylene, terphenylene or naphthenylene, preferably a single bond or phenylene;
- T⁶: is phenylene, biphenylene, terphenylene or naphthenylene;
- Ar¹, Ar², Ar³, Ar⁴ and Ar⁵: may be independently selected from unsubstituted C₆ to C₂₀ aryl, or unsubstituted C₃ to C₂₀ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene], or a unsubstituted aromatic fused ring system comprising at least three unsubstituted aromatic rings selected from the group comprising unsubstituted non-hetero, unsubstituted hetero 5-member rings, unsubstituted 6-member rings and/or unsubstituted 7-member rings, unsubstituted fluorene, or a fused ring system comprising 2 to 6 unsubstituted 5- to 7-member rings and the rings are selected from the group comprising (i) unsaturated 5- to 7-member ring of a heterocycle, (2) 5- to 6-member of an aromatic heterocycle, (3) unsaturated 5- to 7-member ring of a non-heterocycle, (iv) 6-member ring of an aromatic non-heterocycle.

According to an embodiment of the organic electronic device, wherein covalent matrix compound or substantially covalent matrix compound, preferably of the covalent matrix compound or substantially covalent matrix compound of the hole injection layer, comprises a compound of formula (2) or formula (3): wherein 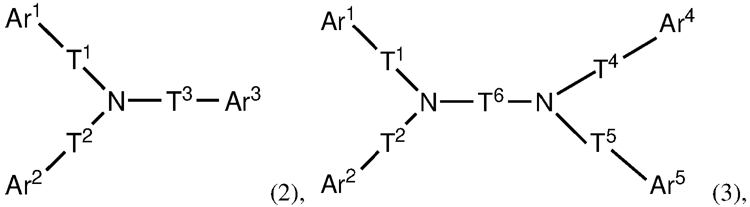
- T¹, T², T³, T⁴ and T⁵: may be independently selected from a single bond, phenylene, biphenylene, terphenylene or naphthenylene, preferably a single bond or phenylene;
- T⁶: is phenylene, biphenylene, terphenylene or naphthenylene;
- Ar¹, Ar², Ar³, Ar⁴ and Ar⁵: may be independently selected from unsubstituted C₆ to C₂₀ aryl, or unsubstituted C₃ to C₂₀ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene].

Thereby, the compound of formula (2) or (3) may have a rate onset temperature suitable for mass production.

According to an embodiment wherein T¹, T², T³, T⁴ and T⁵ may be independently selected from a single bond, phenylene, biphenylene or terphenylene. According to an embodiment wherein T¹, T², T³, T⁴ and T⁵ may be independently selected from phenylene, biphenylene or terphenylene and one of T¹, T², T³, T⁴ and T⁵ are a single bond. According to an embodiment wherein T¹, T², T³, T⁴ and T⁵ may be independently selected from phenylene or biphenylene and one of T¹, T², T³, T⁴and T⁵ are a single bond. According to an embodiment wherein T¹, T², T³, T⁴ and T⁵ may be independently selected from phenylene or biphenylene and two of T¹, T², T³, T⁴ and T⁵ are a single bond.

According to an embodiment wherein T¹, T² and T³ may be independently selected from phenylene and one of T¹, T²and T³ are a single bond. According to an embodiment wherein T¹, T² and T³ may be independently selected from phenylene and two of T¹, T² and T³ are a single bond.

According to an embodiment wherein T⁶ may be phenylene, biphenylene, terphenylene. According to an embodiment wherein T⁶ may be phenylene. According to an embodiment wherein T⁶ may be biphenylene. According to an embodiment wherein T⁶ may be terphenylene.

According to an embodiment wherein Ar¹, Ar², Ar³, Ar⁴ and Ar⁵ may be independently selected from D1 to D16: 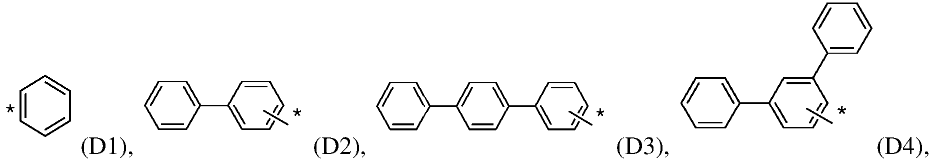 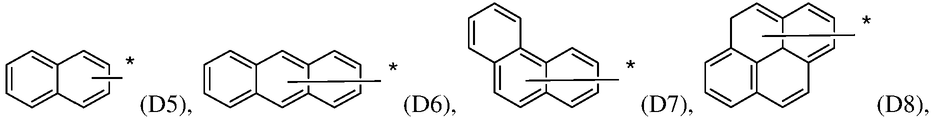 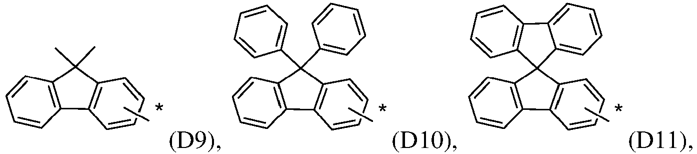 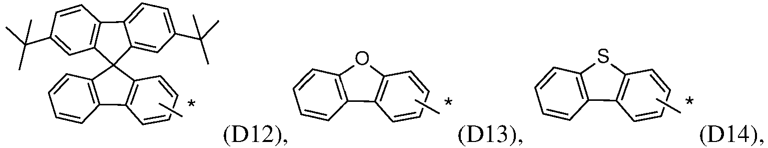 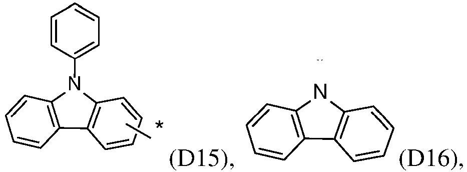 wherein the asterix "*" denotes the binding position.

According to an embodiment, wherein Ar¹, Ar², Ar³, Ar⁴ and Ar⁵ may be independently selected from D1 to D15; alternatively selected from D1 to D10 and D13 to D15.

According to an embodiment, wherein Ar¹, Ar², Ar³, Ar⁴ and Ar⁵ may be independently selected from the group consisting of D1, D2, D5, D7, D9, D10, D13 to D16.

The rate onset temperature may be in a range particularly suited to mass production, when Ar¹, Ar², Ar³, Ar⁴ and Ar⁵ are selected in this range.

The "matrix compound of formula (2) or formula (3) " may be also referred to as "hole transport compound".

According to one embodiment the matrix compound of formula (2) or formula (3) may comprises at least ≥ 1 to ≤ 6 substituted or unsubstituted aromatic fused ring systems comprising heteroaromatic rings.

According to one embodiment the matrix compound of formula (2) or formula (3) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings.

According to one embodiment the matrix compound of formula (2) or formula (3) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings, and at least ≥ 1 to ≤ 3 substituted or unsubstituted unsaturated 5- to 7-member ring of a heterocycle, further preferred 3 or 4 substituted or unsubstituted aromatic fused ring systems comprising heteroaromatic rings and optional at least ≥ 1 to ≤ 3 substituted or unsubstituted unsaturated 5- to 7-member ring of a heterocycle, and additional preferred wherein the aromatic fused ring systems comprising heteroaromatic rings are unsubstituted and optional at least ≥ 1 to ≤ 3 unsubstituted unsaturated 5- to 7-member ring of a heterocycle.

According to one embodiment the matrix compound of formula (2) or formula (3) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems.

According to one embodiment the matrix compound of formula (2) or formula (3) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings.

According to one embodiment the matrix compound of formula (2) or formula (3) may comprise at least ≥ 1 to ≤ 3 or 2 substituted or unsubstituted unsaturated 5- to 7-member ring of a heterocycle.

According to one embodiment the matrix compound of formula (2) or formula (3) may comprise at least ≥ 1 to ≤ 3 or 2 substituted or unsubstituted unsaturated 7-member ring of a heterocycle.

According to one embodiment substituted or unsubstituted aromatic fused ring systems of the covalent matrix compound or substantially covalent matrix compound of formula (2) or formula (3) may comprise at least ≥ 1 to ≤ 3 or 2 substituted or unsubstituted unsaturated 5- to 7-member ring of a heterocycle.

According to one embodiment the substituted or unsubstituted aromatic fused ring systems of the covalent matrix compound or substantially covalent matrix compound of formula (2) or formula (3) may comprise at least ≥ 1 to ≤ 3 or 2 substituted or unsubstituted unsaturated 7-member ring of a heterocycle.

According to one embodiment the matrix compound of formula (2) or formula (3) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, and wherein the aromatic fused ring system comprises substituted or unsubstituted unsaturated 5- to 7-member ring of a heterocycle.

According to one embodiment the matrix compound of formula (2) or formula (3) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings, and wherein the aromatic fused ring system comprises substituted or unsubstituted unsaturated 5- to 7-member ring of a heterocycle.

According to one embodiment the matrix compound of formula (2) or formula (3) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, and wherein the aromatic fused ring system comprises at least ≥ 1 to ≤ 3 or 2 substituted or unsubstituted unsaturated 5- to 7-member ring of a heterocycle.

According to one embodiment the matrix compound of formula (2) or formula (3) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings, and wherein the aromatic fused ring system comprises at least ≥ 1 to ≤ 3 or 2 substituted or unsubstituted unsaturated 5- to 7-member ring of a heterocycle.

According to one embodiment the matrix compound of formula (2) or formula (3) may comprise:
- a substituted or unsubstituted aromatic fused ring system with at least ≥ 2 to ≤ 6, preferably ≥ 3 to ≤ 5, or 4 fused aromatic rings selected from the group comprising substituted or unsubstituted non-hetero aromatic rings, substituted or unsubstituted hetero 5-member rings, substituted or unsubstituted 6-member rings and/or substituted or unsubstituted unsaturated 5-to 7- member ring of a heterocycle; or
- an unsubstituted aromatic fused ring systems with at least ≥ 2 to ≤ 6, preferably ≥ 3 to ≤ 5, or 4 fused aromatic rings selected from the group comprising unsubstituted non-hetero aromatic rings, unsubstituted hetero 5-member rings, unsubstituted 6-member rings and/or unsubstituted unsaturated 5- to 7-member ring of a heterocycle.

It should be noted here that the wording "aromatic fused ring system" may include at least one aromatic ring and at least one substituted or unsubstituted unsaturated 5- to 7- member ring. It should be noted here that the substituted or unsubstituted unsaturated 5- to 7- member ring may not be an aromatic ring.

According to one embodiment the matrix compound of formula (2) or formula (3) may comprise at least at least ≥ 1 to ≤ 6, preferably ≥ 2 to ≤ 5, or further preferred 3 or 4 of the substituted or unsubstituted aromatic fused ring systems with:
- at least one unsaturated 5-member ring, and/or
- at least one unsaturated 6-member ring, and/or
- at least one unsaturated 7-member ring; wherein preferably at least one unsaturated 5- and/or at least one unsaturated 7-member ring comprises at least 1 to 3, preferably 1 hetero-atom.

According to one embodiment the matrix compound of formula (2) or formula (3) may comprise at least at least ≥ 1 to ≤ 6, preferably ≥ 2 to ≤ 5, or further preferred 3 or 4 of the substituted or unsubstituted aromatic fused ring systems with:
- at least one aromatic 5-member ring, and/or
- at least one aromatic 6-member ring, and/or
- at least one aromatic 7-member ring; wherein preferably at least one aromatic 5- and/or at least one aromatic 7-member ring comprises at least 1 to 3, preferably 1 hetero-atom;
wherein the substituted or unsubstituted aromatic fused ring system comprises at least ≥ 1 to ≤ 3 or 2 substituted or unsubstituted unsaturated 5- to 7-member ring of a heterocycle.

According to one embodiment the matrix compound of formula (2) or formula (3) may comprise :
- at least ≥ 6 to ≤ 12, preferably ≥ 7 to ≤ 11, further preferred ≥ 8 to ≤ 10 or 9 aromatic rings; and/or
- at least ≥ 4 to ≤ 11, preferably ≥ 5 to ≤ 10, further preferred ≥ 6 to ≤ 9 or in addition preferred 7 or 8 non-hetero aromatic rings, preferably the non-hetero aromatic rings are aromatic C₆ rings; and/or
- at least ≥ 1 to ≤ 4, preferably 2 or 3 aromatic 5-member-rings, preferably hetero aromatic 5-member-rings; and/or
- at least 1 or 2 unsaturated 5- to 7-member-ring of a heterocycle, preferably at least 1 or 2 unsaturated 7-member-ring of a heterocycle;
- at least ≥ 6 to ≤ 12, preferably ≥ 7 to ≤ 11, further preferred ≥ 8 to ≤ 10 or 9 aromatic rings, wherein therefrom
   at least ≥ 4 to ≤ 11, preferably ≥ 5 to ≤ 10, further preferred ≥ 6 to ≤ 9 or in addition preferred 7 or 8 are non-hetero aromatic rings, and
   at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and/or
- at least ≥ 6 to ≤ 12, preferably ≥ 7 to ≤ 11, further preferred ≥ 8 to ≤ 10 or 9 aromatic rings, wherein therefrom
   at least ≥ 4 to ≤ 11, preferably ≥ 5 to ≤ 10, further preferred ≥ 6 to ≤ 9 or in addition preferred 7 or 8 are non-hetero aromatic rings, and
   at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and
      the hole transport compound or the hole transport compound according to formula I comprises at least ≥ 1 to ≤ 4, preferably 2 or 3 aromatic 5-member-rings, preferably hetero aromatic 5-member-rings, and/or
      the hole transport compound or the hole transport compound according to formula (1) comprises at least 1 or 2 unsaturated 5- to 7-member-ring of a heterocycle, preferably at least 1 or 2 unsaturated 7-member-ring of a heterocycle.

According to one embodiment the matrix compound of formula (2) or formula (3) may comprise a hetero-atom, which may be selected from the group comprising O, S, N, B or P, preferably the hetero-atom may be selected from the group comprising O, S or N.

According to one embodiment the matrix compound of formula (2) or formula (3) may comprise at least at least ≥ 1 to ≤ 6, preferably ≥ 2 to ≤ 5, or further preferred 3 or 4 of the substituted or unsubstituted aromatic fused ring systems with:
- at least one aromatic 5-member ring, and/or
- at least one aromatic 6-member ring, and/or
- at least one aromatic 7-member ring; wherein preferably at least one aromatic 5- and/or at least one aromatic 7-member ring comprises at least 1 to 3, preferably 1 hetero-atom;
   wherein the substituted or unsubstituted aromatic fused ring system optional comprises at least ≥ 1 to ≤ 3 or 2 substituted or unsubstituted unsaturated 5- to 7-member ring of a heterocycle; and wherein the substituted or unsubstituted aromatic fused ring system comprises a hetero-atom, which may be selected from the group comprising O, S, N, B, P or Si, preferably the hetero-atom may be selected from the group comprising O, S or N.

According to one embodiment the matrix compound of formula (2) or formula (3) may be free of hetero-atoms which are not part of an aromatic ring and/or part of an unsaturated 7-member-ring, preferably the hole transport compound or the hole transport compound according to formula (1) may be free on N-atoms except N-atoms which are part of an aromatic ring or are part of an unsaturated 7-member-ring.

According to one embodiment, the hole transport compound comprises at least one naphthyl group, carbazole group, dibenzofurane group, dibenzothiophene group and/or substituted fluorenyl group, wherein the substituents are independently selected from methyl, phenyl or fluorenyl.

According to an embodiment of the electronic device, wherein the covalent matrix compound or substantially covalent matrix compound of formula (2) or formula (3) are selected from F1 to F18:

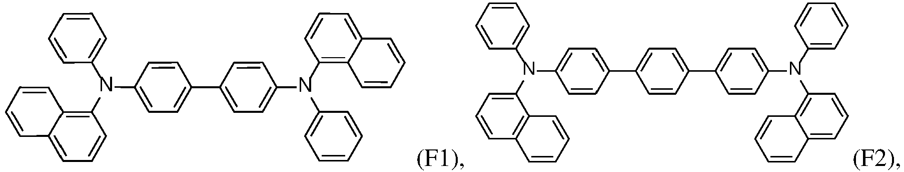

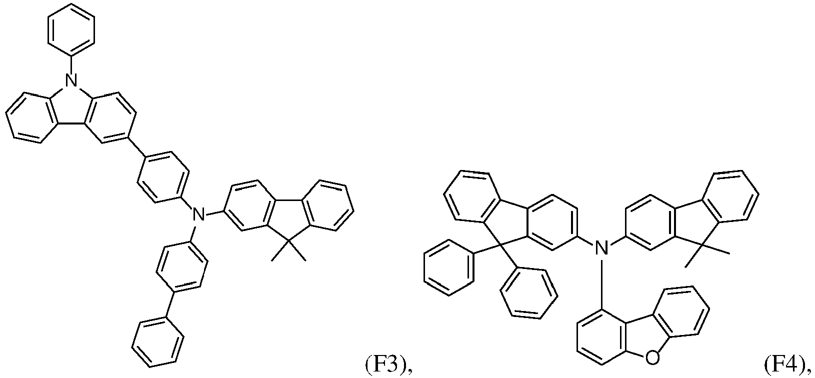

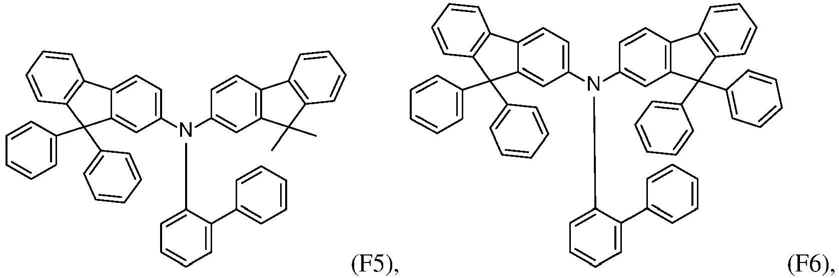

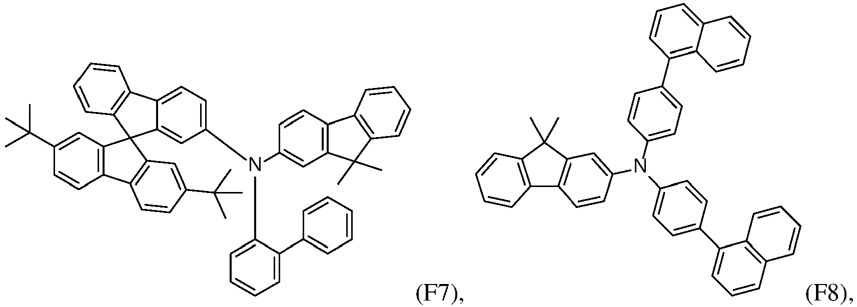

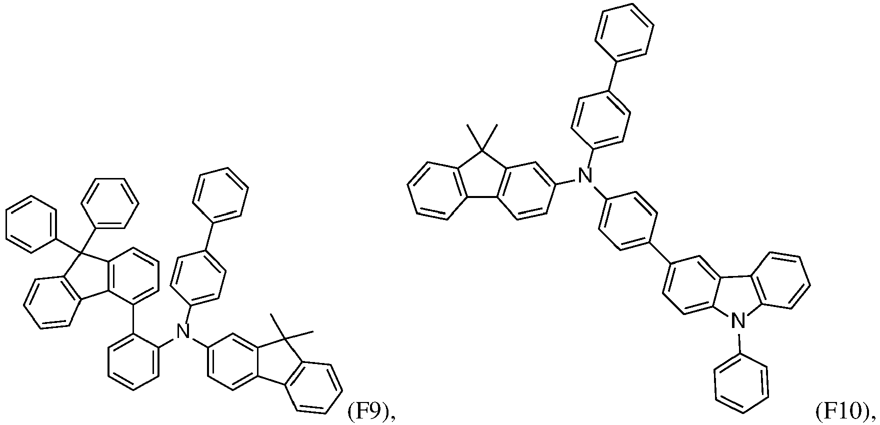

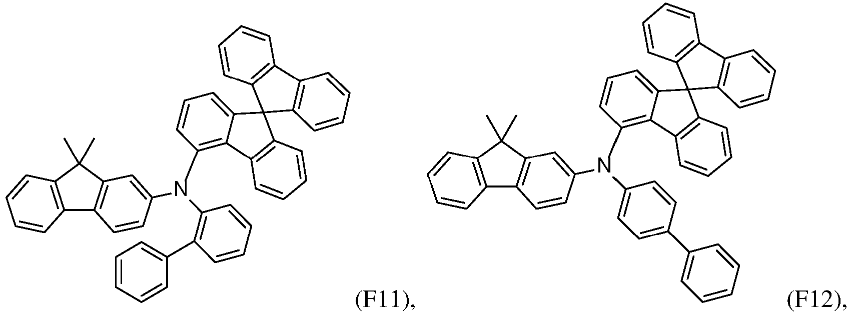

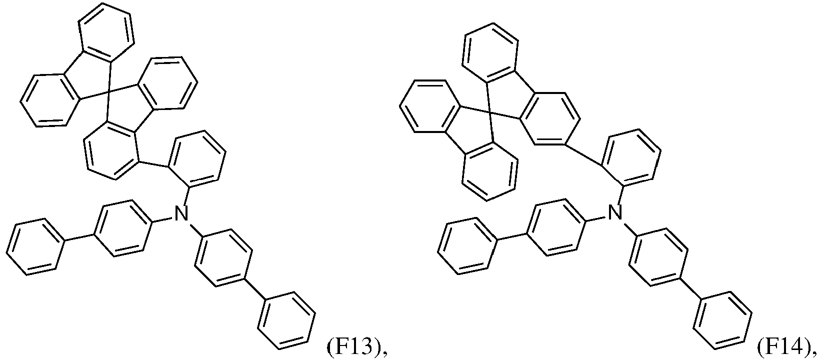

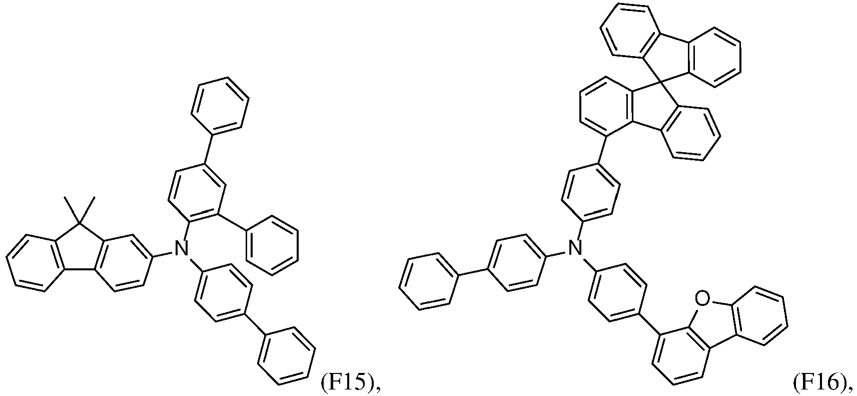

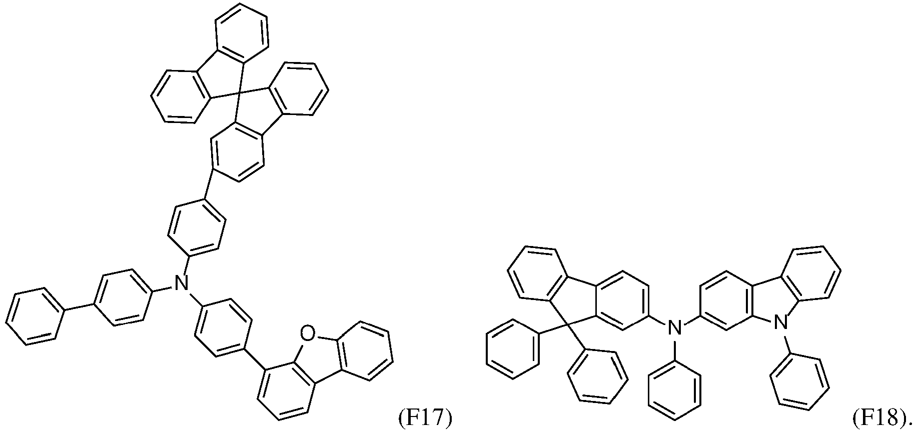

The matrix compound of the hole injection layer may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

According to another aspect, the at least one semiconductor layer further comprises a covalent matrix compound or substantially covalent matrix compound and may comprise:
- at least about ≥ 0.1 wt.-% to about ≤ 50 wt.-%, preferably about ≥ 1 wt.-% to about ≤ 25 wt.-%, and more preferred about ≥ 2 wt.-% to about ≤ 15 wt.-%, of a compound of formula (1), and
- at least about ≥ 50 wt.-% to about ≤ 99 wt.-%, preferably about ≥ 75 wt.-% to about ≤ 99 wt.-%, and more preferred about ≥ 85 wt.-% to about ≤ 98 wt.-%, of a compound of formula (2), (2a) or (2b); preferably the wt.-% of the compound of formula (2), (2a) or (2b) is higher than the wt.-% of the compound of formula (1); wherein the weight-% of the components are based on the total weight of the semiconductor layer.

According to one embodiment of the invention, the at least one semiconductor layer may further comprise a covalent matrix compound or substantially covalent matrix compound and may comprise ≥ 1 and ≤ 30 mol.-% of a compound of formula (1) and 99 and ≥ 70 mol.-% of a covalent matrix compound or substantially covalent matrix compounds; alternatively ≥ 1 and ≤ 10 mol.-% of a compound of formula (1) and ≤ 99 and ≥ 90 mol.-% of a covalent matrix compound or substantially covalent matrix compounds.

According to one embodiment of the invention the electronic organic device is an electroluminescent device, preferably an organic light emitting diode.

The present invention furthermore relates to a display device comprising an organic electronic device according to the present invention.

The present invention furthermore relates to a compound of formula (1a),
- M: is a metal ion; 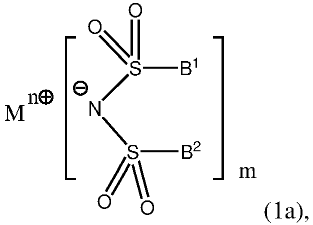
wherein
- n: is the valency of M;
- m: is n;
- B¹: is selected from substituted or unsubstituted pyridyl;
- B²: is selected from C₁ to C₈ alkyl, substituted or unsubstituted C₆ to C₁₉ aryl, substituted or unsubstituted C₂ to C₂₀ heteroaryl, substituted or unsubstituted C₂ to C₂₀ heterocycle;
wherein the substituents on B¹ and B² are independently selected from D, halogen, Cl, F, CN, partially or perfluorinated C₁ to C₈ alkyl, partially or perfluorinated C₁ to C₈ alkoxy;
wherein M is selected from an alkaline earth metal, transition metal or rare earth metal, preferably Cu(II), Ag(I), Zn(II), Fe(II), Fe(III), Mg(II), and more preferred Cu(II), Ag(I), Zn(II) or Fe(II).

According to one embodiment B² is substituted C₆-aryl, a substituted heteroaryl 6-member ring with one N atoms or a substituted heteroaryl of a 5-member ring with one or two heteroatoms selected from N or S, preferably N, and the remaining atoms are C, wherein the substituent is CF₃ or CN.

According to one embodiment B² is selected from the group of perfluorinated C₁ to C₆ alkyl, CF₃, C₂F₅, C₃F₇ or C₄F₉.

According to one embodiment B² is selected from tetra or penta fluorinated C₆-aryl or persubstituted C₆-aryl, wherein 4 substituents are F and one substituent is selected CF₃, C₂F₅, C₃F₇ or C₄F₉, preferably CF₃.

According to one embodiment B² is selected from persubstituted C₆-aryl, wherein 4 substituents are F and one is CN.

According to one embodiment B² is selected from mono-substituted heteroaryl of a 5-member ring with two hetero atoms of N or N and S, wherein the substituent is CN or CF₃, preferably CF₃.

According to one embodiment B² is selected from di-substituted heteroaryl of a 5-member ring with two hetero atoms of N, or N and S, wherein the substituents are CN or CF₃, preferably CF₃.

The present invention furthermore relates to a compound of formula (1b) 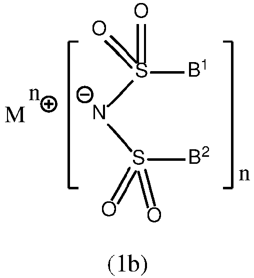 wherein
- M: is a metal ion,
- n: is the valency of M,
- B¹: is selected from substituted or unsubstituted 3-pyridyl;
- B²: is selected from substituted or unsubstituted C₁ to C₈ alkyl, substituted or unsubsituted
- C₆ to C₁₉: aryl, substituted or unsubstituted C₂ to C₂₀ heteroaryl;
wherein the substituents on B¹ and B² are independently selected from D, halogen, Cl, F, CN, partially or perfluorinated C₁ to C₈ alkyl, partially or perfluorinated C₁ to C₈ alkoxy;
n is an integer from 1 to 4.

According to one embodiment of the present invention, M is selected from an alkali, alkaline earth metal, transition metal or rare earth metal, preferably Li(I), Cu(II), Ag(I), Zn(II), Fe(II), Fe(III), Mg(II), and more preferred Cu(II), Ag(I), Zn(II) or Fe(II).

According to one embodiment of the present invention, M is selected from a transition metal and n is 1 or 2.

According to one embodiment B² is substituted C₆-aryl, a substituted heteroaryl 6-member ring with one N atoms or a substituted heteroaryl of a 5-member ring with one or two heteroatoms selected from N or S, preferably N, and the remaining atoms are C, wherein the substituent is CF₃ or CN.

According to one embodiment B² is selected from the group of perfluorinated C₁ to C₆ alkyl, CF₃, C₂F₅, C₃F₇ or C₄F₉.

According to one embodiment B² is selected from tetra or penta fluorinated C₆-aryl or persubstituted C₆-aryl, wherein 4 substituents are F and one substituent is selected CF₃, C₂F₅, C₃F₇ or C₄F₉, preferably CF₃.

According to one embodiment B² is selected from persubstituted C₆-aryl, wherein 4 substituents are F and one is CN.

According to one embodiment B² is selected from mono-substituted heteroaryl of a 5-member ring with two hetero atoms of N or N and S, wherein the substituent is CN or CF₃, preferably CF₃.

According to one embodiment B² is selected from di-substituted heteroaryl of a 5-member ring with two hetero atoms of N, or N and S, wherein the substituents are CN or CF₃, preferably CF₃.

The negative charge in compounds of formula (1) may be delocalized partially or fully over the N(SO₂)₂ group and optionally also over the B¹ and/or B² groups.

Any specifications of formula (1) as described above in the context of the organic electronic device apply *mutatis mutandis.*

### Further layers

In accordance with the invention, the organic electronic device may comprise, besides the layers already mentioned above, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a backplane for a display.

### Anode electrode

The anode electrode, also named anode layer, may be formed by depositing or sputtering a material that is used to form the anode electrode. The material used to form the anode electrode may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode electrode may also be formed using metals, typically silver (Ag), gold (Au), or metal alloys.

### Hole injection layer

A hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10⁻⁸ to 10⁻³ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecyl benzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

### Hole transport layer

A hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

In one embodiment of the present invention, the organic electronic device further comprises a hole transport layer, wherein the hole transport layer is arranged between the semiconductor layer and the at least one photoactive layer.

In one embodiment, the hole transport layer comprises a covalent matrix compound or substantially covalent matrix compound.

In one embodiment of the present invention, the at least one semiconductor layer and the hole transport layer comprise a covalent matrix compound or substantially covalent matrix compound, wherein the covalent matrix compound or substantially covalent matrix compound is selected the same in both layers.

In one embodiment, the hole transport layer comprises a compound of formula (2)or (3).

In one embodiment of the present invention, the at least one semiconductor layer and the hole transport layer comprise a compound of formula (2), (2a) or (2b).

In one embodiment of the present invention, the at least one semiconductor layer comprises a compound of formula (1) and a compound of formula (2), (2a) or (2b) and the hole transport layer comprises a compound of formula (2), (2a) or (2b), wherein the compound of formula (2), (2a) or (2b) are selected the same.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm.

When the thickness of the HTL is within this range, the HTL may have excellent hole transporting characteristics, without a substantial penalty in driving voltage.

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime may be improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

### Photoactive layer (PAL)

The photoactive layer converts an electrical current into photons or photons into an electrical current.

The PAL may be formed on the HTL by vacuum deposition, spin coating, slot-die coating, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.

It may be provided that the photoactive layer does not comprise the compound of Formula (1).

The photoactive layer may be a light-emitting layer or a light-absorbing layer.

### Emission layer (EML)

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

It may be provided that the emission layer does not comprise the compound of Formula (1).

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters; however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and triazine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The organic electronic device according to the present invention may further comprise an electron transport layer (ETL).

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a triazine compound.

### Electron injection layer (EIL)

An optional EIL, which may facilitate injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode electrode

The cathode electrode, also named cathode layer, is formed on the ETL or optional EIL. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy.

It is to be understood that the cathode electrode is not part of an electron injection layer or the electron transport layer.

### Organic light-emitting diode (OLED)

The organic electronic device according to the invention may be an organic light-emitting device.

According to one aspect of the present invention, there is provided an organic light-emitting diode (OLED) comprising: a substrate; an anode electrode formed on the substrate; an semiconductor layer comprising compound of formula (1) , a hole transport layer, an emission layer, an electron transport layer and a cathode electrode.

According to another aspect of the present invention, there is provided an OLED comprising: a substrate; an anode electrode formed on the substrate; a semiconductor layer comprising a compound of Formula (1), a hole transport layer, an electron blocking layer, an emission layer, a hole blocking layer, an electron transport layer and a cathode electrode.

According to another aspect of the present invention, there is provided an OLED comprising: a substrate; an anode electrode formed on the substrate; a semiconductor layer comprising a compound of Formula (1), a hole transport layer, an electron blocking layer, an emission layer, a hole blocking layer, an electron transport layer, an electron injection layer, and a cathode electrode.

According to various embodiments of the present invention, there may be provided OLEDs layers arranged between the above-mentioned layers, on the substrate or on the top electrode.

According to one aspect, the OLED may comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer, the n-type charge generation layer is adjacent arranged to a hole generating layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode electrode an optional electron transport layer and/or an optional injection layer are arranged.

The semiconductor layer according to the invention may be the first hole injection layer and p-type charge generation layer.

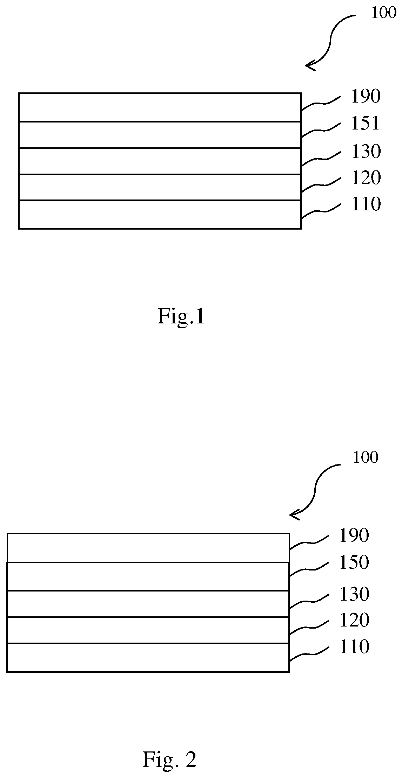

For example, the OLED according to Fig. 2 may be formed by a process, wherein on a substrate (110), an anode (120), a hole injection layer (130), a hole transport layer (140), an electron blocking layer (145), an emission layer (150), a hole blocking layer (155), an electron transport layer (160), an electron injection layer (180) and the cathode electrode (190) are subsequently formed in that order.

### Organic electronic device

The organic electronic device according to the invention may be a light emitting device, or a photovoltaic cell, and preferably a light emitting device.

According to another aspect of the present invention, there is provided a method of manufacturing an organic electronic device, the method using:
- at least one deposition source, preferably two deposition sources and more preferred at least three deposition sources.

The methods for deposition that can be suitable comprise:
- deposition via vacuum thermal evaporation;
- deposition via solution processing, preferably the processing is selected from spin-coating, printing, casting; and/or
- slot-die coating.

According to various embodiments of the present invention, there is provided a method using:
- a first deposition source to release the compound of Formula (1) according to the invention, and
- a second deposition source to release the covalent matrix compound or substantially covalent matrix compound;
the method comprising the steps of forming the semiconductor layer; whereby for an organic light-emitting diode (OLED):
- the semiconductor layer is formed by releasing the compound of Formula (1) according to the invention from the first deposition source and the covalent matrix compound or substantially covalent matrix compound from the second deposition source.

According to various embodiments of the present invention, the method may further include forming on the anode electrode, at least one layer selected from the group consisting of forming a hole transport layer or forming a hole blocking layer, and an emission layer between the anode electrode and the first electron transport layer.
According to various embodiments of the present invention, the method may further include the steps for forming an organic light-emitting diode (OLED), wherein
- on a substrate an anode electrode is formed,
- on the anode electrode a semiconductor layer comprising a compound of formula (1) is formed,
- on the semiconductor layer comprising a compound of formula (1) a hole transport layer is formed,
- on the hole transport layer an emission layer is formed,
- on the emission layer an electron transport layer is formed, optionally a hole blocking layer is formed on the emission layer,
- and finally, a cathode electrode is formed,
- optional a hole blocking layer is formed in that order between the first anode electrode and the emission layer,
- optional an electron injection layer is formed between the electron transport layer and the cathode electrode.

According to various embodiments, the OLED may have the following layer structure, wherein the layers having the following order:
anode, semiconductor layer comprising a compound of Formula (1) according to the invention, first hole transport layer, second hole transport layer, emission layer, optional hole blocking layer, electron transport layer, optional electron injection layer, and cathode.

According to another aspect of the invention, it is provided an electronic device comprising at least one organic light emitting device according to any embodiment described throughout this application, preferably, the electronic device comprises the organic light emitting diode in one of embodiments described throughout this application. More preferably, the electronic device is a display device.

Hereinafter, the embodiments are illustrated in more detail with reference to examples. However, the present disclosure is not limited to the following examples. Reference will now be made in detail to the exemplary aspects.

### Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

### Figures 1 to 4

FIG. 1 is a schematic sectional view of an organic electronic device, according to an exemplary embodiment of the present invention;
FIG. 2 is a schematic sectional view of an organic light-emitting diode (OLED), according to an exemplary embodiment of the present invention;
FIG. 3 is a schematic sectional view of an organic light-emitting diode (OLED), according to an exemplary embodiment of the present invention.
FIG. 4 is a schematic sectional view of an organic light-emitting diode (OLED), according to an exemplary embodiment of the present invention;

Hereinafter, the figures 1 to 4 are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic electronic device 100, according to an exemplary embodiment of the present invention. The organic electronic device 101 includes a substrate (110), an anode layer (120), a semiconductor layer according to the present invention (130), a photoactive layer (PAL) (151) and a cathode layer (190).

FIG. 2 is a schematic sectional view of an organic light-emitting diode (OLED) 100, according to an exemplary embodiment of the present invention. The OLED 100 includes a substrate (110), an anode layer (120), a semiconductor layer according to the present invention (130), an emission layer (EML) (150) and a cathode layer (190).

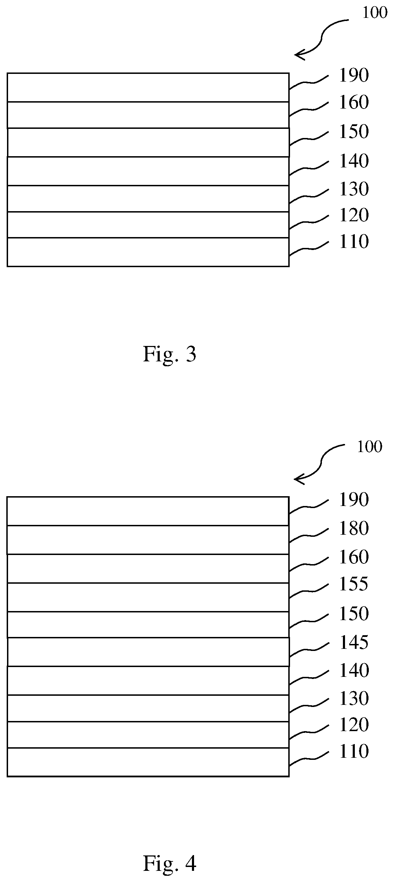

FIG. 3 is a schematic sectional view of an organic light-emitting diode (OLED) 100, according to an exemplary embodiment of the present invention. The OLED 100 includes a substrate (110), an anode layer (120), a semiconductor layer according to the present invention (130), a hole transport layer (HTL) (140), an emission layer (EML) (150), an electron transport layer (ETL) (160) and a cathode layer (190).

FIG. 4 is a schematic sectional view of an organic light-emitting diode (OLED) 100, according to an exemplary embodiment of the present invention. The OLED 100 includes a substrate (110), an anode layer (120), a semiconductor layer according to the present invention (130), a hole transport layer (HTL) (140), an electron blocking layer (EBL) (145), an emission layer (EML) (150), a hole blocking layer (HBL) (155), an electron transport layer (ETL) (160), an optional electron injection layer (EIL) (180), and a cathode layer (190).

In the description above the method of manufacture an organic electronic device 100 of the present invention is for example started with a substrate (110) onto which an anode layer (120) is formed, on the anode layer (120), a semiconductor layer comprising compound of Formula (I) (130), a photoactive layer (151) and a cathode electrode 190 are formed, exactly in that order or exactly the other way around.

In the description above the method of manufacture an OLED 100 of the present invention is started with a substrate (110) onto which an anode layer (120) is formed, on the anode layer (120), a semiconductor layer comprising compound of Formula (I) (130), optional a hole transport layer (140), optional an electron blocking layer (145), an emission layer (150), optional a hole blocking layer (155), optional an electron transport layer (160), optional an electron injection layer (180), and a cathode electrode 190 are formed, exactly in that order or exactly the other way around.

The semiconductor layer of the present invention (130) can be a hole injection layer.

While not shown in Fig. 1 to Fig. 4, a capping layer and/or a sealing layer may further be formed on the cathode electrodes 190, in order to seal the OLEDs 100. In addition, various other modifications may be applied thereto.

Hereinafter, the embodiments are illustrated in more detail with reference to examples. However, the present disclosure is not limited to the following examples.

### Detailed description

The invention is furthermore illustrated by the following examples which are illustrative only and non-binding.

The compound may be prepared as described in the literature or alternative compounds may be prepared following similar compounds as described in the literature.

### Compounds of formula (1), (1a) or (1b), wherein M is Ag(I) or Li(I):

In the following the preparation of several inventive compounds is shown, using the following General Method A:

The sulfonamide ligands were synthesized by methods known in the literature.

The sulfonamide ligand was dissolved in MeOH (ca. 5ml/g) and 0.55 eq M₂CO₃ were added. The reaction mixture was stirred overnight at room temperature. Excess silver carbonate was filtered off and washed with a small amount of methanol. The liquid phases were combined and the solvent was removed under reduced pressure. The remaining solid was dried in high vacuum. The crude material was purified by recrystallization and/or precipitation.

### Compounds of formula (1), (1a) or (1b), wherein M is Cu(II) or Zn(II):

In the following the preparation of several inventive compounds is shown, using the following General Method B:

The sulfonamide ligands were synthesized by methods known in the literature.

The sulfonamide ligand was dissolved in water (ca 10ml/g) and 0.5 eq of Cu(OAc)₂ was added. The mixture was stirred until a clear solution was obtained. The solvent was removed under reduced pressure. Residual acetic acid was removed by repeated adding of toluene and removal of the solvent under reduced pressure. The crude material was purified by recrystallization and/or precipitation.

### Compounds of formula (1), (1a) or (1b), wherein M is Fe(II):

In the following the preparation of several inventive compounds is shown, using the following General Method C:

The sulfonamide ligands were synthesized by methods known in the literature.

The sulfonamide ligand was dissolved in water (ca 10ml/g) and 0.5 eq of Fe powder was added. The mixture was stirred until a solution was obtained. The solvent was removed under reduced pressure. Residual acetic acid was removed by repeated adding of toluene and removal of the solvent under reduced pressure. The crude material was purified by recrystallization and/or precipitation.

### HOMO and LUMO

The HOMO and LUMO energy levels of the matrix compounds are calculated with the program package TURBOMOLE V6.5 (TURBOMOLE GmbH, Litzenhardtstrasse 19, 76135 Karlsruhe, Germany). The optimized geometries and the energy levels of the molecular structures are determined by applying the hybrid functional B3LYP with a 6-31G* basis set in the gas phase. If more than one conformation is viable, the conformation with the lowest total energy is selected. In case of the metal complexes, the LUMO energy of the ligand was calculated for the charge-neutral ligand which was saturated with a proton bound to the nitrogen atom.

### Rate onset temperature

The rate onset temperature (T_{RO}) is determined by loading 100 mg compound into a VTE source. As VTE source a point source for organic materials may be used as supplied by Kurt J. Lesker Company (www.lesker.com) or CreaPhys GmbH (http://www.creaphys.com). The VTE source is heated at a constant rate of 15 K/min at a pressure of less than 10⁻⁵ mbar and the temperature inside the source measured with a thermocouple. Evaporation of the compound is detected with a QCM detector which detects deposition of the compound on the quartz crystal of the detector. The deposition rate on the quartz crystal is measured in Ǻngstrom per second. To determine the rate onset temperature, the deposition rate is plotted against the VTE source temperature. The rate onset is the temperature at which noticeable deposition on the QCM detector occurs. For accurate results, the VTE source is heated and cooled three time and only results from the second and third run are used to determine the rate onset temperature.

To achieve good control over the evaporation rate of an organic compound, the rate onset temperature may be in the range of 200 to 255 °C. If the rate onset temperature is below 200 °C the evaporation may be too rapid and therefore difficult to control. If the rate onset temperature is above 255 °C the evaporation rate may be too low which may result in low tact time and decomposition of the organic compound in VTE source may occur due to prolonged exposure to elevated temperatures.

The rate onset temperature is an indirect measure of the volatility of a compound. The higher the rate onset temperature the lower is the volatility of a compound.

### General method for preparation of the ink formulation

To prepare the ink formulation, under inert atmosphere the compounds were weighed into vials. Then, the solvent was added. The mixture was stirred at 60 °C for 10 min. After cooling to room temperature, an aliquot of benzonitrile solutions was added to the anisole solution to obtain a solution with a ratio of 5:1 of anisole to benzonitrile solution. The resulting solution was stirred again for at least 10 min at room temperature. The resulting ink formulation had a solid content of 3 wt.-%.

### Ink formulation for comparative Example 1

The ink formulation for comparative example 1 has the following composition: 0.86 wt.-% LiTFSI : F3 in anisole : benzonitrile (5:1).

To prepare the ink, solutions of 13 mg LiTFSI in 8ml benzonitrile and of 153 mg F3 in 4.2ml anisol were prepared as described above. 0.8 ml benonitrile solution was added to the anisole solution and stirred as described above.

### Ink formulation for example 1

The ink formulation for example 1 has the following composition: 0.88 wt.-%_MC-5 : F3 in anisole : benzonitrile (5:1).

To prepare the ink, solutions of 14 mg MC-5 in 8 ml benzonitrile and 153 mg F3 in 4.2 ml anisole were prepared as described above. 0.8 ml benzonitrile solution was added to the anisole solution and stirred as described above.

### Ink formulation for example 2

The ink formulation for example 2 has the following composition: 2.29 wt.-%_MC-1 : F3 in anisole : benzonitrile (5:1).

To prepare the ink, solutions of 11 mg MC-1 in 2.4 ml benzonitrile and 151 mg F3 in 4.2 ml anisole were prepared as described above. 0.8 ml benonitrile solution was added to the anisole solution and stirred as described above.

### Ink formulation for example 3

The ink formulation for example 3 has the following composition: 2.26 wt.-%_MC-2 : F3 in anisole : benzonitrile (5:1).

To prepare the ink, solutions of 11 mg MC-2 in 2.4ml benzonitrile and of 151mg F3 in 4.2 ml anisol were prepared as described above. 0.8 ml benonitrile solution was added to the anisole solution and stirred as described above.

### General procedure for fabrication of OLEDs

For OLEDs, see Example 1 to 3, and comparative examples 1 in Table 3, a 15Ω /cm² glass substrate with 90 nm ITO (available from Corning Co.) with the dimensions 150 mm x 150 mm x 0.7 mm was ultrasonically washed with isopropyl alcohol for 5 minutes and then with pure water for 5 minutes and dried at elevated temperature, followed by plasma treatment in an atmosphere of 98-99% nitrogen and 2-1% oxygen at a pressure of 7.5 mTorr at 100W for 35s-40s to prepare the anode layer.

To form the hole injection layer having a thickness of 45 nm on the anode layer, the substrate is placed on a spin-coater with ITO side facing upwards and fixed with vacuum. 5 ml of ink formulation is applied with a syringe with filter (PTFE - 0,45µm) on the substrate. Spin-coating parameter are 850 rpm (3sec ramp-up from zero tomaximum speed) for 30sec. The resulting film is dried at 60°C for 1 minute on a hotplate. Next step is the cleaning of the substrate around the active area (to ensure a good encapsulation process after evaporation). An additional bake-out at 100°C for 10 minutes on a hotplate is done. In comparative example 1, LiTFSI (CAS 90076-65-6) was used in place of compounds of formula (1). The composition of the hole injection layer can be seen in Table 3.

Then, the substrate is transferred to a vacuum chamber.

Then, Biphenyl-4-yl(9,9-diphenyl-9H-fluoren-2-yl)-[4-(9-phenyl-9H-carbazol-3-yl) phenyl]-amine was vacuum deposited on the HIL, to form a first HTL having a thickness of 89 nm.

Then N,N-di([1,1'-biphenyl]-4-yl)-3'-(9H-carbazol-9-yl)-[1,1'-biphenyl]-4-amine (CAS 1464822-27-2) was vacuum deposited on the HTL, to form an electron blocking layer (EBL) having a thickness of 5 nm.

Then 97 vol.-% H09 (Sun Fine Chemicals, Korea) as EML host and 3 vol.-% BD200 (Sun Fine Chemicals, Korea) as fluorescent blue dopant were deposited on the EBL, to form a first blue-emitting emission layer (EML) with a thickness of 20 nm.

Then a hole blocking layer is formed with a thickness of 5 nm by depositing 2-(3'-(9,9-dimethyl-9H-fluoren-2-yl)-[1,1'-biphenyl]-3-yl)-4,6-diphenyl-1,3,5-triazine on the emission layer.

Then, the electron transporting layer having a thickness of 31 nm is formed on the hole blocking layer by depositing 4'-(4-(4-(4,6-diphenyl-1,3,5-triazin-2-yl)phenyl)naphthalen-1-yl)-[1,1'-biphenyl]-4-carbonitrile and LiQ in a ratio of 50:50 vol.-%.

Then, an electron injection layer is formed having a thickness of 2 nm by depositing Yb onto the electron transport layer.

Then, A1 is evaporated at a rate of 0.01 to 1 Å/s at 10-7 mbar to form a cathode layer with a thickness of 100 nm onto the electron injection layer.

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m² using an Instrument Systems CAS-140CT array spectrometer (calibrated by Deutsche Akkreditierungsstelle (DAkkS)) for each of the voltage values.

To determine the EQE in % the light output of the device is measured using a calibrated photodiode at 15 mA/cm2.

Lifetime LT of the device is measured at ambient conditions (20°C) and 30 mA/cm², using a Keithley 2400 sourcemeter, and recorded in hours. The brightness of the device is measured using a calibrated photo diode. The lifetime LT is defined as the time till the brightness of the device is reduced to 97 % of its initial value.

To determine the voltage stability over time U(50h-1h), a current density of at 30 mA/cm2 was applied to the device. The operating voltage U was measured after 1 hour and after 50 hours, followed by calculation of the voltage stability for the time period of 1 hour to 50 hours.

### Technical effect of the invention

In Table 1 are shown physical properties of compounds of formula (1).

**Table 1: Compounds of formula (1)**

| Name | Chemical formula | LUMO of the charge neutral ligand L-H (eV) |
|---|---|---|
| Comparative compound 1 | LiTFSI | -1.1 |
| MC-1 | 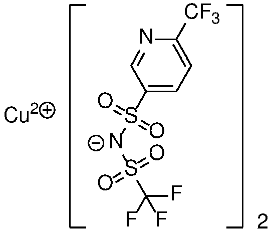 | -2.0 eV |
| MC-2 | 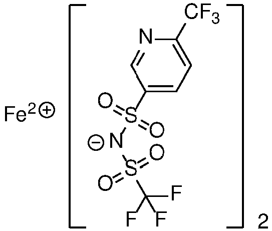 | -2.5 |
| MC-3 | 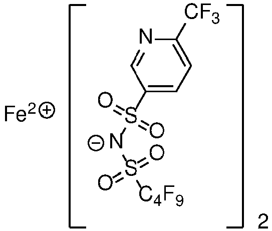 | -2.5 |
| MC-4 | 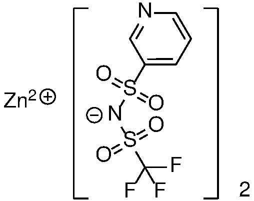 | -2.0 |
| MC-5 | 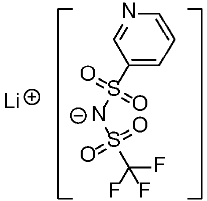 | -2.0 |

As can be seen in Table 1, the compounds of formula (1) have a LUMO further away from vacuum level compared to comparative example 1. Without being bound by theory, a LUMO level of the ligand selected in the range of ≤ 2 to ≥ 3 eV may be beneficial for performance of organic electronic devices, in particular of an organic semiconductor layer comprising a compound of formula (1) and a covalent matrix compound or substantially covalent matrix compound.

In Table 2 are shown the calculated HOMO levels for matrix compounds of formula (2) or (3). HOMO levels were calculated as described above.

**Table 2: Matrix compounds of formula (2) or (3)**

| Name | Structure | HOMO level (eV) |
|---|---|---|
| Biphenyl-4-yl(9,9-diphenyl-9H-fluoren-2-yl)-[4-(9-phenyl-9H-carbazol-3-yl)phenyl]-amine | 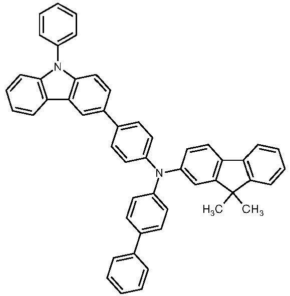 | -4.69 |
| F3 | | |
| N,N'-Bis(naphthalen-1-yl)-N,N'-bis(phenyl)-benzidine | 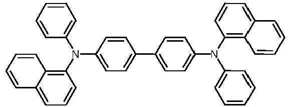 | -4.72 |
| F1 | | |
| N4,N4"-di(naphthalen-1-yl)-N4,N4"-diphenyl-[1,1':4',1"-terphenyl]-4,4"-diamine (CAS 139255-16-6) | 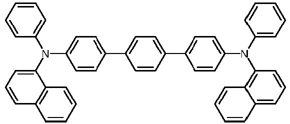 | -4.81 |
| F2 | | |
| N-(9,9-dimethyl-9H-fluoren-2-yl)-N-(9,9-diphenyl-9H-fluoren-2-yl)dibenzo[b,d]furan-1-amine | 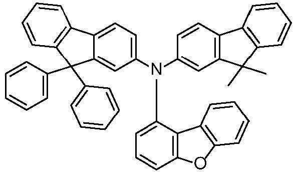 | -4.82 |
| F4 | | |
| 9,9-dimethyl-N,N-bis(4-(naphthalen-1-yl)phenyl)-9H-fluoren-2-amine | 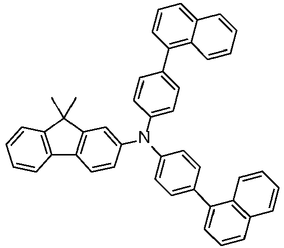 | -4.84 |
| F8 | | |
| N-([1,1'-biphenyl]-4-yl)-N-(2-(9,9-diphenyl-9H-fluoren-4-yl)phenyl)-9,9-dimethyl-9H-fluoren-2-amine | 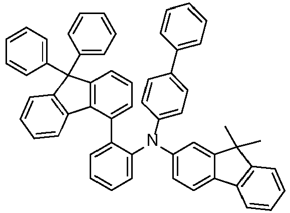 | -4.84 |
| F9 | | |
| N-(9,9-diphenyl-9H-fluoren-2-yl)-N,9-diphenyl-9H-carbazol-2-amine | 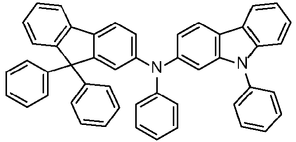 | -4.73 |
| F18 | | |

As can be seen in Table 2, the matrix compound of formula (2) or (3) have HOMO levels suitable for mass production of organic electronic devices.

In Table 3 are shown performance data of organic electronic devices according to invention and comparative example 1.

In comparative example 1, the organic semiconductor layer comprises LiFTSI and substantially covalent matrix compound F2. LiTFSI is free of a substituted or unsubstituted C2 to C20 heteroaryl. The operating voltage is 4.35 V, the external quantum efficiency EQE is 10.4 %, the lifetime is 15 hours and the operating voltage rise over time is 13.5 V.

In Example 1, the organic semiconductor layer comprises compound of formula (1) MC-5. MC-5 differs from LiTFSI in B¹ being 3-pyridyl. Compared to comparative example 1, the operating voltage is improved to 4.01 V, the EQE is improved to 11.6 %, the lifetime is improved to 18 hours and the voltage stability is improved to 2.4 V.

In Example 2, the organic semiconductor layer comprises compound of formula (1) MC-. MC-1 differs from MC-5 in the metal cation and group B¹. Compared to example 1, the lifetime is improved to 24 hours and the voltage stability is improved to 1.6 V.

In Example 3, the organic semiconductor layer comprises compound of formula (1) MC-. MC-2 differs from MC-1 in the metal cation. Compared to example 2, the operating voltage is further improved to 4.00 V, the lifetime is substantially improved to 79 hours and the voltage stability is substantially improved to 0.2 V.

Low operating voltage may be beneficial for low power consumption and improved battery life, in particular in mobile devices.

Long lifetime and improved voltage stability over time may be beneficial for long-term stability of devices.

In summary, a substantial improvement of in operating voltage, lifetime and/or voltage stability over time has been obtained.

**Table 3: Performance of an organic electronic device comprising a hole injection layer comprising a compound of formula (1) and a compound of formula (2) or (3) and comparative example 1**

| | Compound of formula (1) | Concentration of Compound of formula (1) (mol.-%) | Compound of formula (2) or (3) | Concentration of compound of formula (2) or (3) (mol.-%) | Operating voltage U at 15 mA/cm² (V) | EQE at 15 mA/cm² (%) | LT at 30 mA/cm² (h) | U(50h-1h) at 30 mA/cm² (V) |
|---|---|---|---|---|---|---|---|---|
| Comparative example 1 | LiTFSI | 2 | F3 | 98 | 4.35 | 10.4 | 15 | 13.5 |
| Example 1 | MC-5 | 2 | F3 | 98 | 4.01 | 11.6 | 18 | 2.4 |
| Example 2 | MC-1 | 2 | F3 | 98 | 4.14 | 9.5 | 24 | 1.6 |
| Example 3 | MC-2 | 2 | F3 | 98 | 4.00 | 9.7 | 79 | 0.2 |

The particular combinations of elements and features in the above detailed embodiments are exemplary only; the interchanging and substitution of these teachings with other teachings in this and the patents/applications incorporated by reference are also expressly contemplated.

Accordingly, the foregoing description is by way of example only and is not intended as limiting. In the claims, the word "comprising" does not exclude other elements or steps, and the indefinite article "a" or "an" does not exclude a plurality. The scope of the present invention is defined by the appended claims.

## Claims

1. An organic electronic device comprising an anode (120), a cathode (190), at least one photoactive laye (151) and at least one semiconductor layer, wherein the at least one semiconductor layer (130) is arranged between the anode and the at least one photoactive layer; and **characterized in that** at least one semiconductor layer comprises:
- a compound of Formula (1): 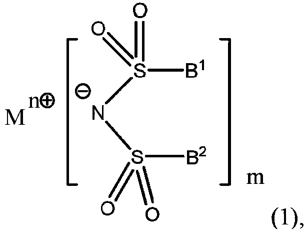 wherein
M is a metal ion;
n is the valency of M;
m is n;
B¹ is selected from substituted or unsubstituted C₂ to C₂₀ heteroaryl;
B² is selected from C₁ to C₈ alkyl, substituted or unsubstituted C₆ to C₁₉ aryl, substituted or unsubstituted C₂ to C₂₀ heteroaryl, substituted or unsubstituted C₂ to C₂₀ heterocycle;
wherein
the substituents on B¹ and B² are independently selected from D, halogen, Cl, F, CN,
partially or perfluorinated C₁ to C₈ alkyl, partially or perfluorinated C₁ to C₈ alkoxy; and
- a covalent matrix compound or substantially covalent matrix compound, wherein the calculated HOMO of the covalent matrix compound or substantially covalent matrix compound is in the range of < -4.5 eV and > 6.5 eV, wherein the HOMO is calculated with program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

2. The organic electronic device of claim 1, wherein the substituents on B¹ and B² are independently selected from the group comprising halogen, wherein the halogen is preferably selected F, C₁ to C₃ perhalogenated, wherein the C₁ to C₃ perhalogenated is preferably perfluorinated, partially or perfluorinated C₁ to C₆ alkoxy, or -(O)₁-C_{q}H_{2q}-CₚHalₚ₂ₚ₊₁ with l = 0 or 1, preferably 0, q = 1 or 2, preferably 1 and p = 1 to 3, preferably 1 or 2 and Hal = halogen, preferably F.

3. The organic electronic device of claim 1 or 2, wherein B¹ is selected from the group comprising substituted or unsubstituted pyridyl or substituted or unsubstituted 3-pyridyl.

4. The organic electronic device according to any of claims 1 to 3, wherein M is selected from a metal ion wherein the corresponding metal has an electronegativity value according to Allen of less than 2.4.

5. The organic electronic device according to any of claims 1 to 4, wherein M is selected from an alkaline earth metal, transition metal or rare earth metal, preferably Cu(II), Ag(I), Zn(II), Fe(II), Fe(III), Mg(II), and more preferred Cu(II), Ag(I), Zn(II) or Fe(II).

6. The organic electronic device according to any of claims 1 to 5, wherein M has an atomic mass of ≥ 22 Da.

7. The organic electronic device of any of the claims 1 to 6, whereby the anion of the compounds of Formula (1) is selected from A-1 to A-71:

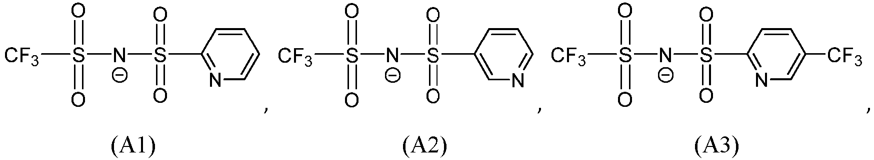

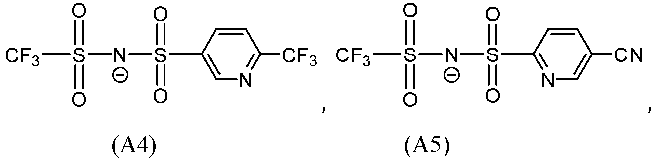

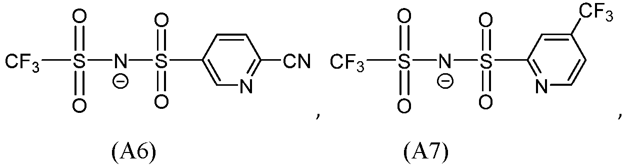

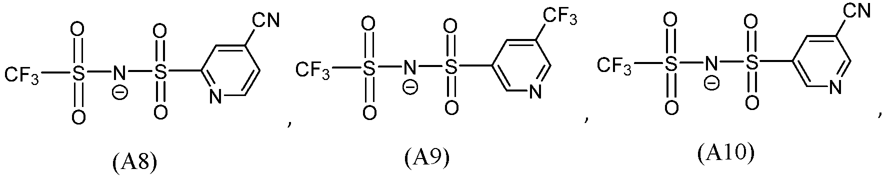

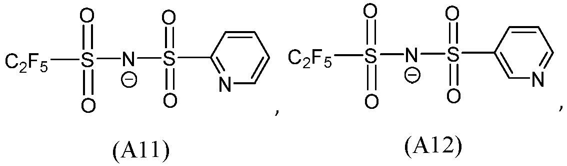

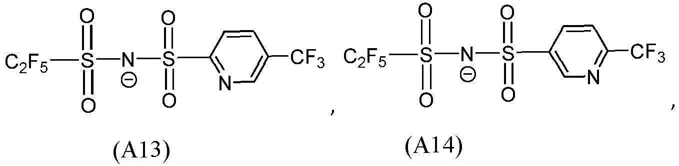

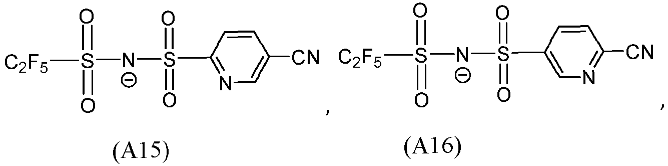

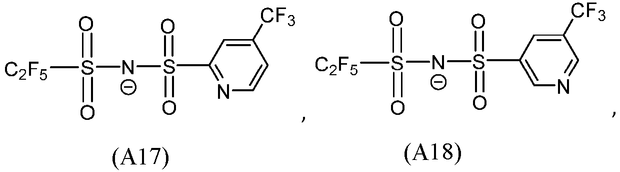

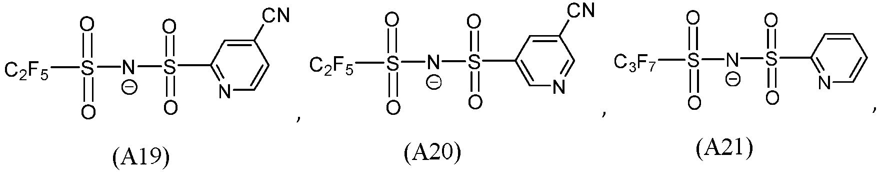

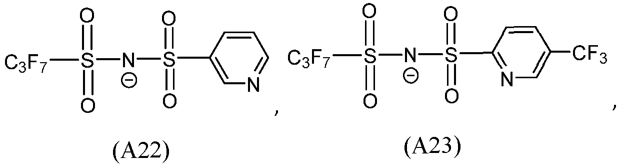

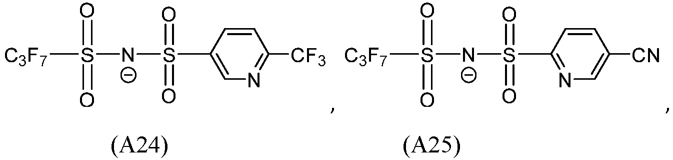

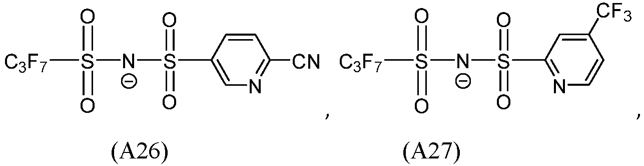

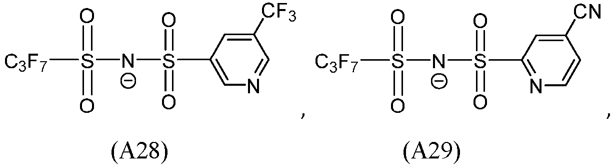

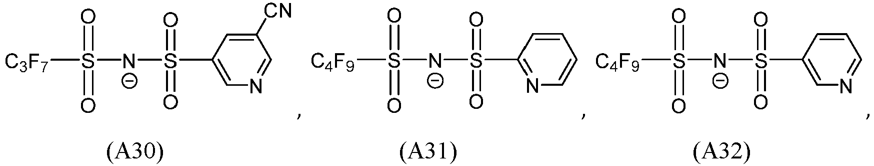

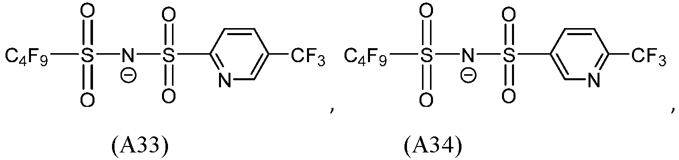

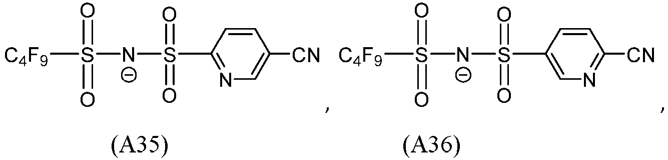

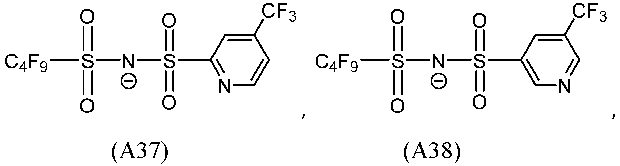

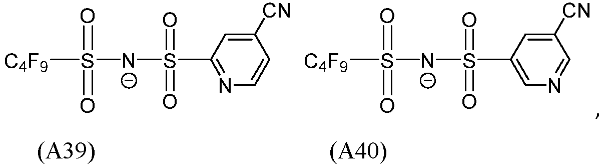

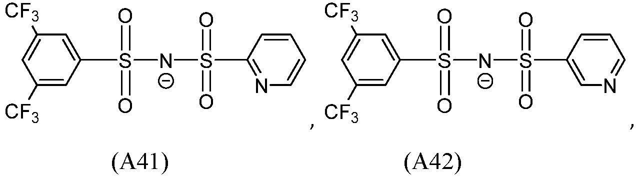

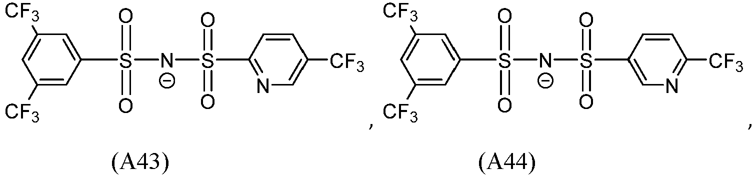

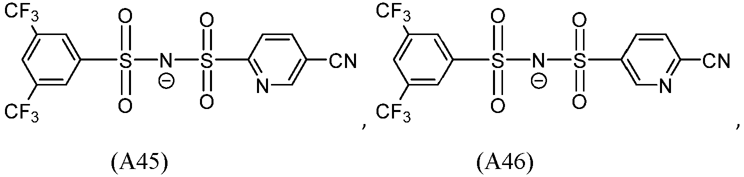

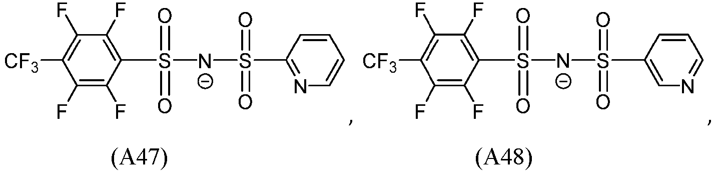

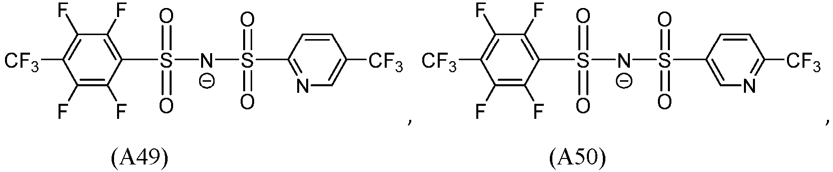

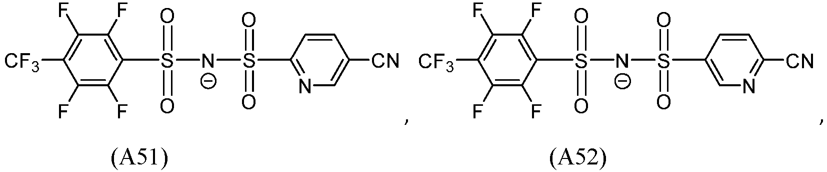

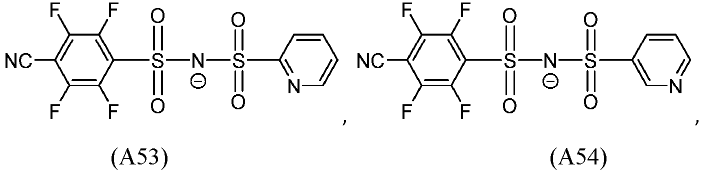

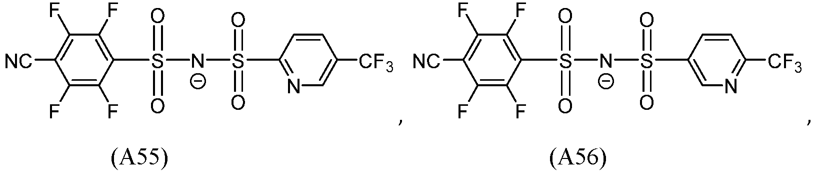

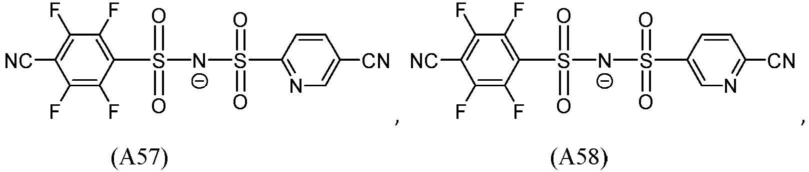

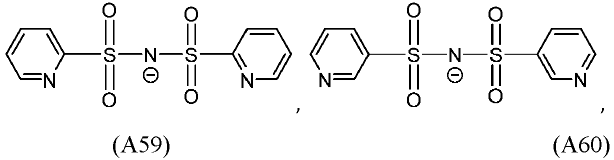

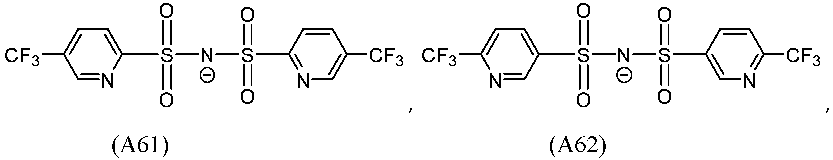

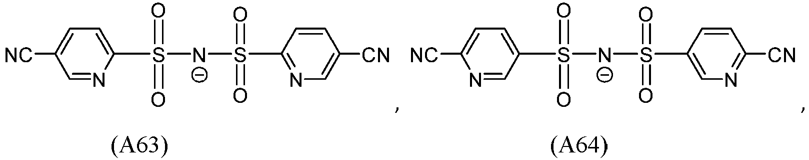

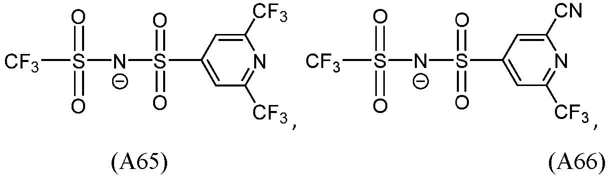

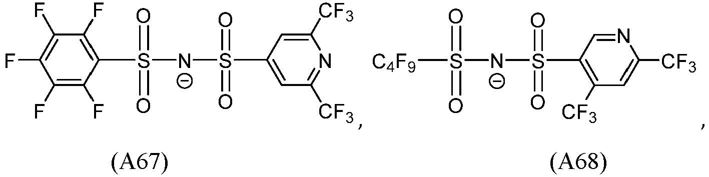

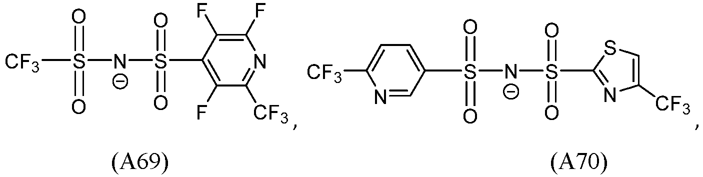

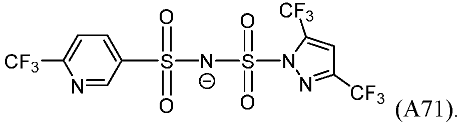

8. The organic electronic device according to any of the claims 1 to 7, wherein the compounds of formula (I) are selected from the group D1 to D8:

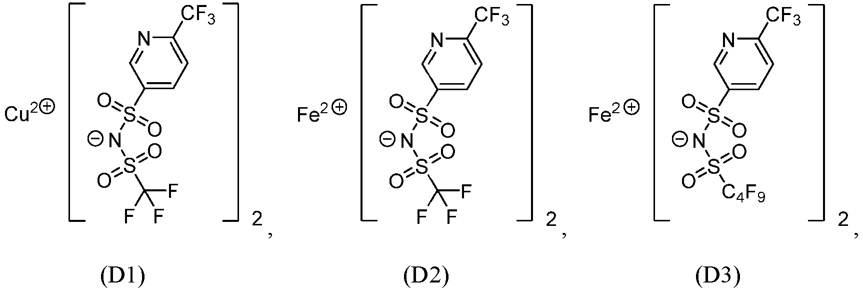

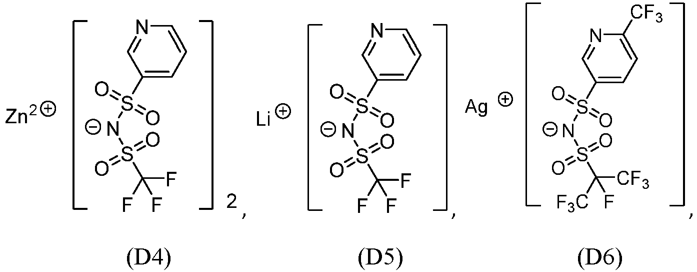

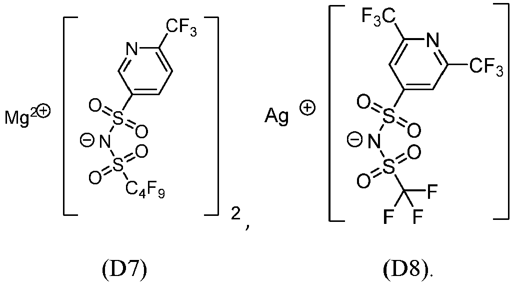

9. The organic electronic device according to any of the claims 1 to 8, wherein the at least one semiconductor layer is an organic semiconductor layer, preferably a hole injection layer, and preferably the at least one semiconductor layer is non-emissive.

10. The organic electronic device according to any of the claims 1 to 9, wherein at least one semiconductor layers further comprises a covalent matrix compound or a substantially covalent matrix compound, preferably the covalent matrix compound or a substantially covalent matrix compound is selected from at least one arylamine compound, a diarylamine compound or a triarylamine compound.

11. The electronic organic device according to any of the claims 1 to 10, wherein the electronic organic device is an electroluminescent device, preferably an organic light emitting diode.

12. A display device comprising an organic electronic device according to any of the claims 1 to 11.

13. A compound of formula (1) comprising formula (1a) or (1b): 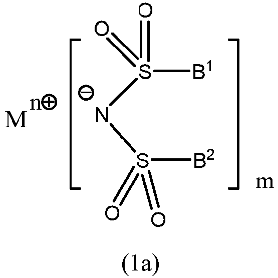 wherein
M is a metal ion;
n is the valency of M;
m is n;
B¹ is selected from substituted or unsubstituted pyridyl;
B² is selected from C₁ to C₈ alkyl, substituted or unsubstituted C₆ to C₁₉ aryl, substituted or unsubstituted C₂ to C₂₀ heteroaryl, substituted or unsubstituted C₂ to C₂₀ heterocycle; wherein
the substituents on B¹ and B² are independently selected from D, halogen, Cl, F, CN,
partially or perfluorinated C₁ to C₈ alkyl, partially or perfluorinated C₁ to C₈ alkoxy;
wherein
M is selected from an alkaline earth metal, transition metal or rare earth metal, preferably Cu(II), Ag(I), Zn(II), Fe(II), Fe(III), Mg(II), and more preferred Cu(II), Ag(I), Zn(II) or Fe(II); or 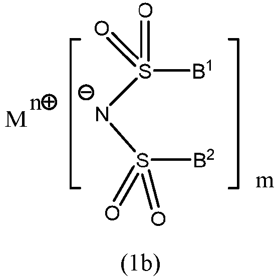 wherein
M is a metal ion;
n is the valency of M;
m is n;
B¹ is selected from substituted or unsubstituted 3-pyridyl;
B² is selected from substituted or unsubstituted C₁ to C₈ alkyl, substituted or unsubsituted C₆ to C₁₉ aryl, substituted or unsubstituted C₂ to C₂₀ heteroaryl;
wherein the substituents on B¹ and B² are independently selected from D, halogen, Cl, F, CN, partially or perfluorinated C₁ to C₈ alkyl, partially or perfluorinated C₁ to C₈ alkoxy;
n is an integer from 1 to 4.

## Patentansprüche

1. Organische elektronische Vorrichtung, umfassend eine Anode (120), eine Kathode (190), mindestens eine photoaktive Schicht (151) und mindestens eine Halbleiterschicht, wobei die mindestens eine Halbleiterschicht (130) zwischen der Anode und der mindestens einen photoaktiven Schicht angeordnet ist; und **dadurch gekennzeichnet, dass** mindestens eine Halbleiterschicht umfasst:
- eine Verbindung der Formel (1): 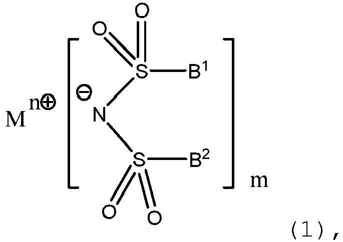 wobei
M für ein Metallion steht;
n für die Wertigkeit von M steht;
m für n steht;
B¹ aus substituiertem oder unsubstituiertem C₂- bis C₂₀-Heteroaryl ausgewählt ist;
B² aus C₁- bis C₈-Alkyl, substituiertem oder unsubstituiertem C₆- bis C₁₉-Aryl, substituiertem oder unsubstituiertem C₂- bis C₂₀-Heteroaryl, substituiertem oder unsubstituiertem C₂- bis C₂₀-Heterocyclyl ausgewählt ist;
wobei
die Substituenten an B¹ und B² unabhängig aus D, Halogen, Cl, F, CN, teil- oder perfluoriertem C₁- bis C₈-Alkyl, teil- oder perfluoriertem C₁- bis C₈-Alkoxy ausgewählt sind; und
- eine kovalente Matrixverbindung oder weitgehend kovalente Matrixverbindung, wobei das berechnete HOMO der kovalenten Matrixverbindung oder weitgehend kovalenten Matrixverbindung im Bereich von < -4,5 eV und > 6,5 eV liegt, wobei das HOMO mit dem Programmpaket TURBOMOLE V6.5 (TURBOMOLE GmbH, Litzenhardtstrasse 19, 76135 Karlsruhe, Deutschland) durch Anwenden des Hybridfunktionals B3LYP mit einem 6-31G*-Basissatz in der Gasphase berechnet wird.

2. Organische elektronische Vorrichtung nach Anspruch 1, wobei die Substituenten an B¹ und B² unabhängig aus der Gruppe umfassend Halogen, wobei das Halogen vorzugsweise ausgewählt ist aus der Gruppe F, perhalogeniertes C₁ bis C₃, wobei das perhalogenierte C₁ bis C₃ vorzugsweise perfluoriert ist, teil- oder perfluoriertes C₁- bis C₆-Alkoxy oder -(O)ₗ-C_{q}H_{2q}-CₚHalₚ₂ₚ₊₁ mit 1 = 0 oder 1, vorzugsweise 0, q = 1 oder 2, vorzugsweise 1, und p = 1 bis 3, vorzugsweise 1 oder 2, und Hal = Halogen, vorzugsweise F, ausgewählt ist.

3. Organische elektronische Vorrichtung nach Anspruch 1 oder 2, wobei B¹ aus der Gruppe umfassend substituiertes oder unsubstituiertes Pyridyl oder substituiertes oder unsubstituiertes 3-Pyridyl ausgewählt ist.

4. Organische elektronische Vorrichtung nach einem der Ansprüche 1 bis 3, wobei M aus einem Metallion ausgewählt ist, wobei das entsprechende Metall einen Elektronegativitätswert gemäß Allen von weniger als 2,4 aufweist.

5. Organische elektronische Vorrichtung nach einem der Ansprüche 1 bis 4, wobei M aus einem Erdalkalimetall, Übergangsmetall oder Seltenerdmetall, vorzugsweise Cu(II), Ag(I), Zn(II), Fe(II), Fe(III), Mg(II) und weiter bevorzugt Cu(II), Ag(I), Zn(II) oder Fe(II) ausgewählt ist.

6. Organische elektronische Vorrichtung nach einem der Ansprüche 1 bis 5, wobei M eine Atommasse von ≥ 22 Da aufweist.

7. Organische elektronische Vorrichtung nach einem der Ansprüche 1 bis 6, wobei das Anion der Verbindungen der Formel (1) aus A-1 bis A-71 ausgewählt ist:

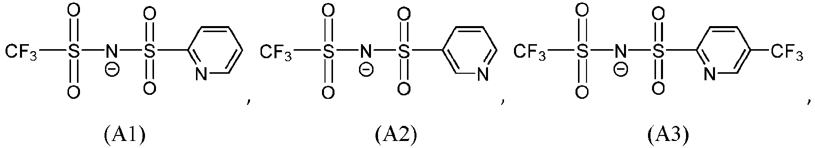

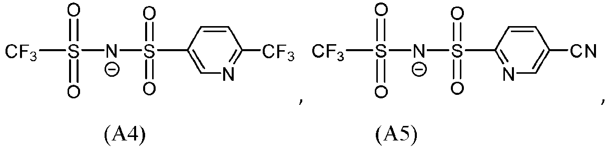

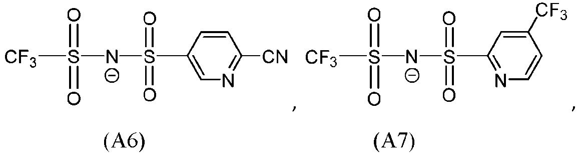

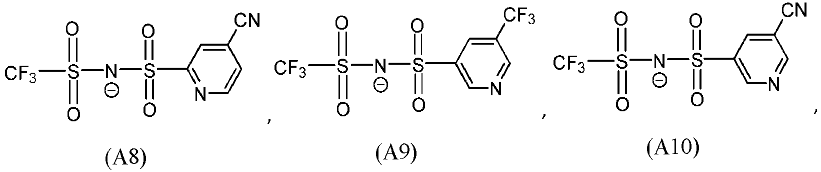

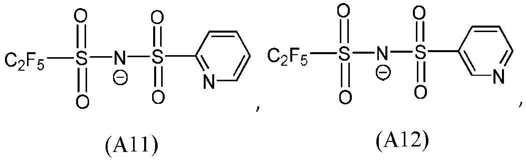

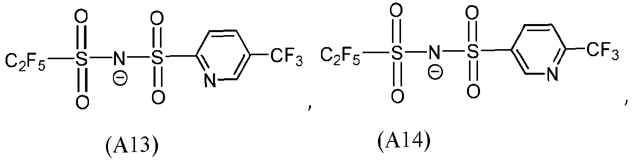

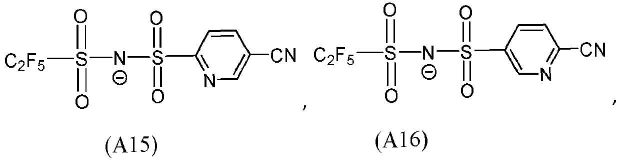

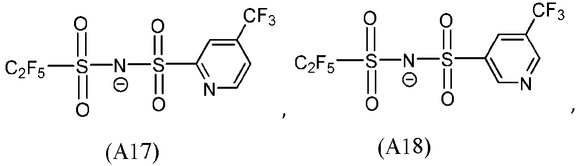

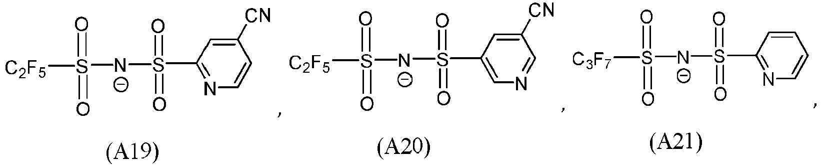

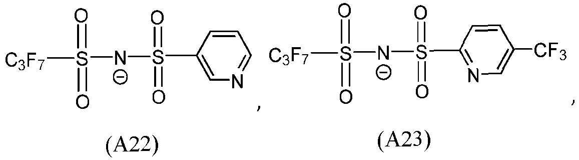

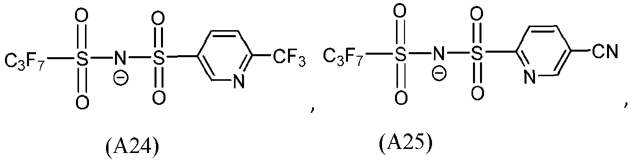

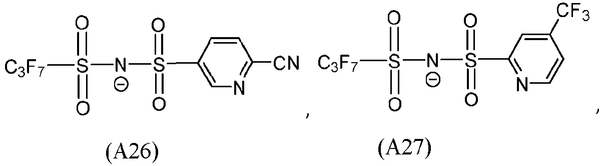

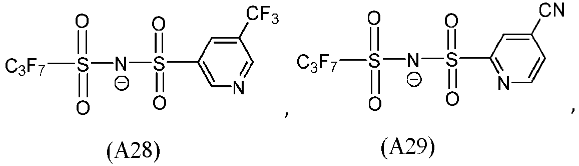

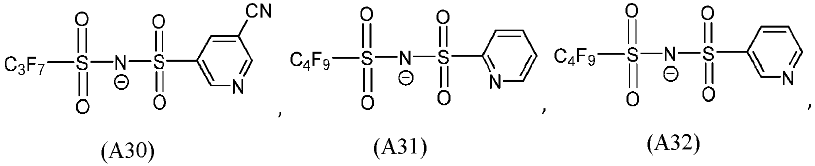

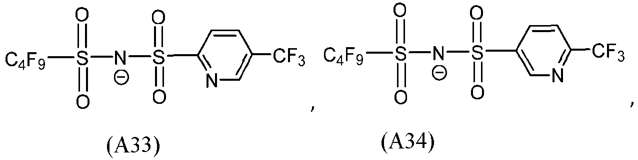

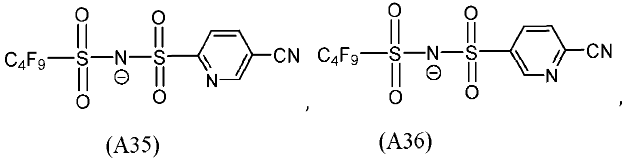

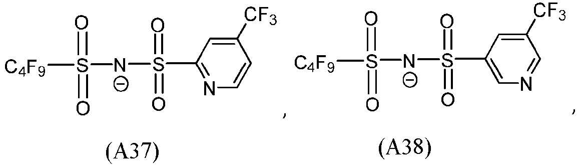

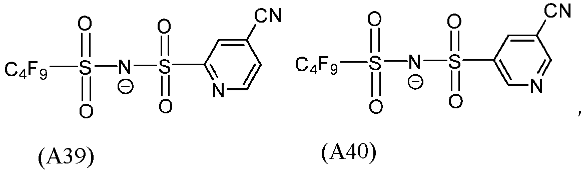

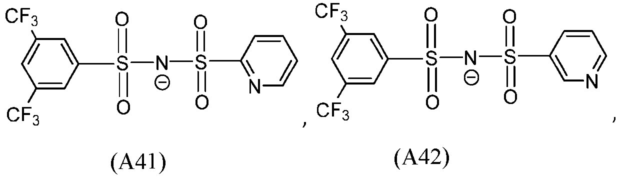

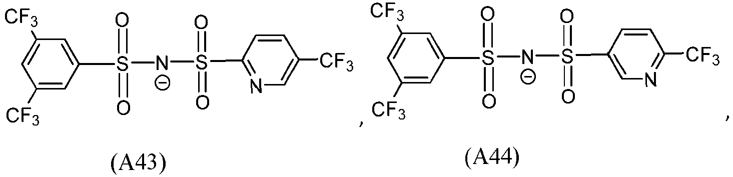

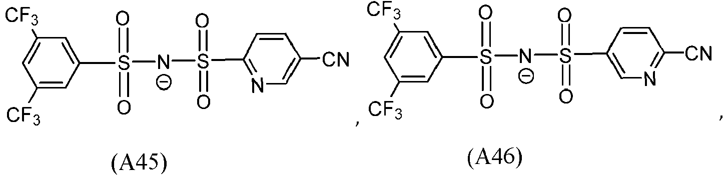

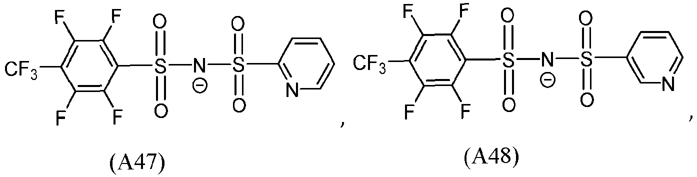

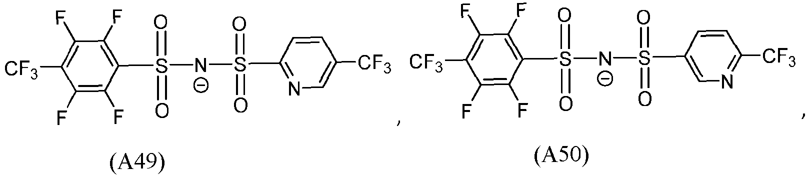

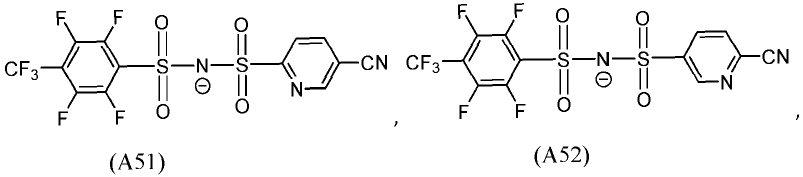

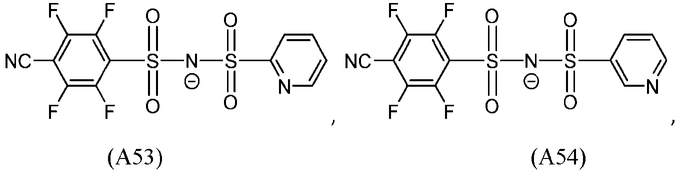

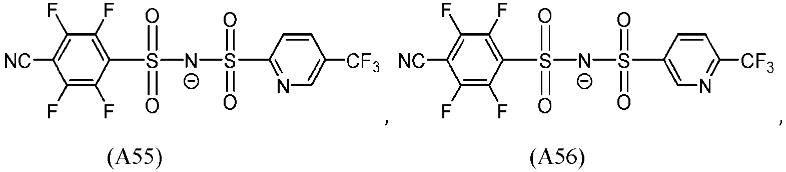

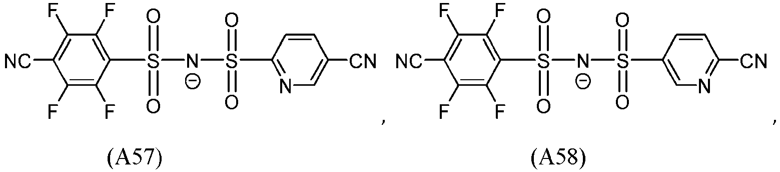

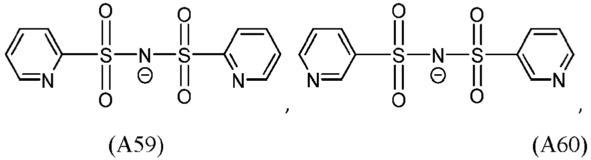

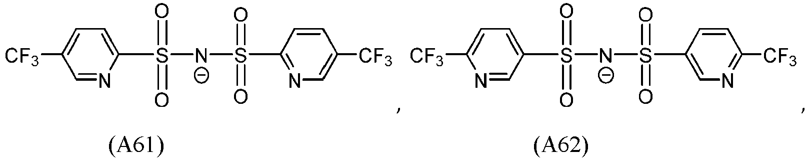

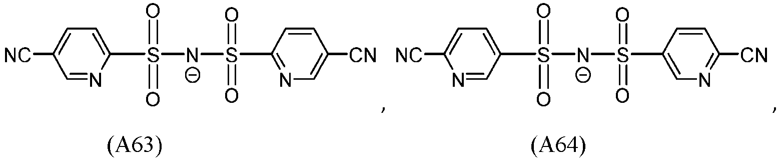

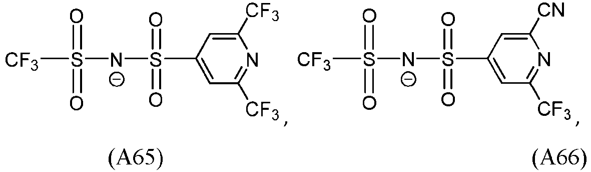

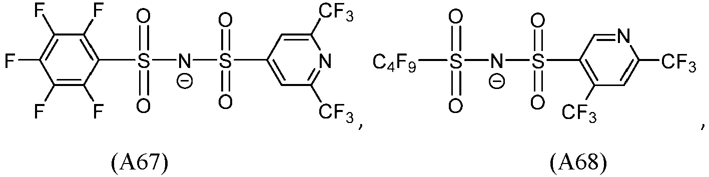

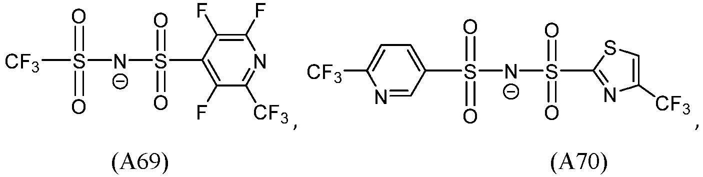

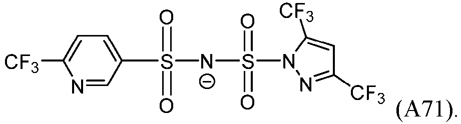

8. Organische elektronische Vorrichtung nach einem der Ansprüche 1 bis 7, wobei die Verbindungen der Formel (I) aus der Gruppe D1 bis D8 ausgewählt sind:

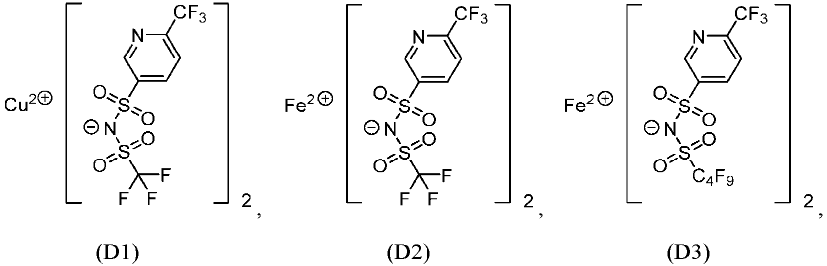

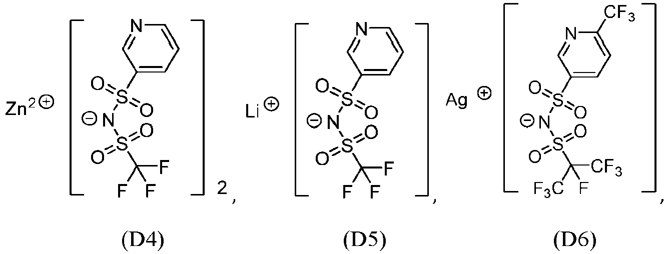

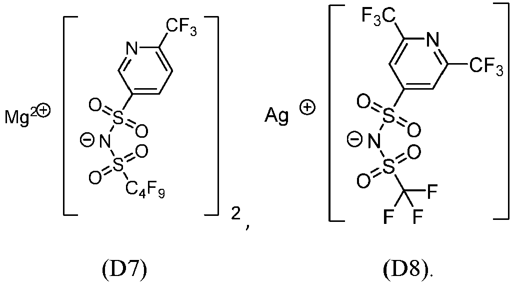

9. Organische elektronische Vorrichtung nach einem der Ansprüche 1 bis 8, wobei es sich bei der mindestens einen Halbleiterschicht um eine organische Halbleiterschicht, vorzugsweise eine Lochinjektionsschicht, handelt und vorzugsweise die mindestens eine Halbleiterschicht nichtemissiv ist.

10. Organische elektronische Vorrichtung nach einem der Ansprüche 1 bis 9, wobei mindestens eine Halbleiterschicht ferner eine kovalente Matrixverbindung oder eine weitgehend kovalente Matrixverbindung umfasst, wobei vorzugsweise die kovalente Matrixverbindung oder eine weitgehend kovalente Matrixverbindung aus mindestens einer Arylaminverbindung, einer Diarylaminverbindung oder einer Triarylaminverbindung ausgewählt ist.

11. Organische elektronische Vorrichtung nach einem der Ansprüche 1 bis 10, wobei es sich bei der elektronischen organischen Vorrichtung um eine Elektrolumineszenzvorrichtung, vorzugsweise eine organische Leuchtdiode, handelt.

12. Anzeigevorrichtung, umfassend eine organische elektronische Vorrichtung nach einem der Ansprüche 1 bis 11.

13. Verbindung der Formel (1), umfassend Formel (1a) oder (1b): 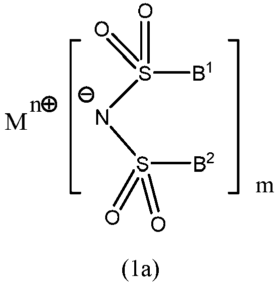 wobei
M für ein Metallion steht;
n für die Wertigkeit von M steht;
m für n steht;
B¹ aus substituiertem oder unsubstituiertem Pyridyl ausgewählt ist;
B² aus C₁- bis C₈-Alkyl, substituiertem oder unsubstituiertem C₆- bis C₁₉-Aryl, substituiertem oder unsubstituiertem C₂- bis C₂₀-Heteroaryl, substituiertem oder unsubstituiertem C₂- bis C₂₀-Heterocyclyl ausgewählt ist;
wobei
die Substituenten an B¹ und B² unabhängig aus D, Halogen, Cl, F, CN, teil- oder perfluoriertem C₁- bis C₈-Alkyl, teil- oder perfluoriertem C₁- bis C₈-Alkoxy ausgewählt sind;
wobei
M aus einem Erdalkalimetall, Übergangsmetall oder Seltenerdmetall, vorzugsweise Cu(II), Ag(I), Zn(II), Fe(II), Fe(III), Mg(II) und weiter bevorzugt Cu(II), Ag(I), Zn(II) oder Fe(II) ausgewählt ist oder 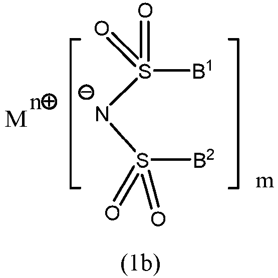
wobei
M für ein Metallion steht;
n für die Wertigkeit von M steht;
m für n steht;
B¹ aus substituiertem oder unsubstituiertem 3-Pyridiyl ausgewählt ist;
B² aus substituiertem oder unsubstituiertem C₁- bis C₈-Alkyl, substituiertem oder unsubstituiertem C₆- bis C₁₉-Aryl, substituiertem oder unsubstituiertem C₂- bis C₂₀-Heteroaryl ausgewählt ist;
wobei die Substituenten an B¹ und B² unabhängig aus D, Halogen, Cl, F, CN, teil- oder perfluoriertem C₁- bis C₈-Alkyl, teil- oder perfluoriertem C₁- bis C₈-Alkoxy ausgewählt sind;
n für eine ganze Zahl von 1 bis 4 steht.

## Revendications

1. Dispositif électronique organique comprenant une anode (120), une cathode (190), au moins une couche photoactive (151) et au moins une couche de semi-conducteur, dans lequel la au moins une couche de semi-conducteur (130) est agencée entre l'anode et la au moins une couche photoactive ; et **caractérisé en ce qu'**au moins une couche de semi-conducteur comprend :
- un composé de Formule (1) : 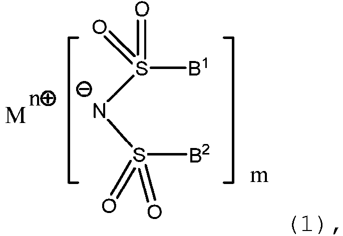
M étant un ion métallique ;
n étant la valence de M ;
m étant n ;
B¹ étant choisi parmi hétéroaryle en C₂ à C₂₀ substitué ou non substitué ;
B₂ étant choisi parmi alkyle en C₁ à C₈, aryle en C₆ à C₁₉ substitué ou non substitué, hétéroaryle en C₂ à C₂₀ substitué ou non substitué, hétérocycle en C₂ à C₂₀ substitué ou non substitué ;
les substituants sur B¹ et B² étant indépendamment choisis parmi D, halogène, Cl, F, CN, alkyle en C₁ à C₈ partiellement ou perfluoré, alcoxy en C₁ à C₈ partiellement ou perfluoré ; et
- un composé matriciel covalent ou un composé matriciel sensiblement covalent, dans lequel l'HOMO calculée du composé matriciel covalent ou du composé matriciel sensiblement covalent est dans la plage <-4,5 eV et >6,5 eV, l'HOMO étant calculée avec le progiciel TURBOMOLE V6.5 (TURBOMOLE GmbH, Litzenhardtstrasse 19, 76135 Karlsruhe, Allemagne) par application du B3LYP hybride fonctionnel avec un ensemble de base 6-31G* dans la phase gazeuse.

2. Dispositif électronique organique selon la revendication 1, dans lequel les substituants sur B¹ et B² sont choisis indépendamment dans le groupe comprenant halogène, dans lequel l'halogène étant de préférence choisi parmi le groupe F, C₁ à C₃ perhalogéné, dans lequel le C₁ à C₃ perhalogéné est de préférence perfluoré, alcoxy en C₁ à C₆ partiellement ou perfluoré, ou -(O)ₗ-C_{q}H_{2q}-CₚHalₚ₂ₚ₊₁ avec 1 = 0 ou 1, de préférence 0, q = 1 ou 2, de préférence 1 et p = 1 à 3, de préférence 1 ou 2 et Hal = halogène, de préférence F.

3. Dispositif électronique organique selon la revendication 1 ou 2, dans lequel B¹ est choisi dans le groupe comprenant pyridinyle substitué ou non substitué ou 3-pyridinyle substitué ou non substitué.

4. Dispositif électronique organique selon l'une quelconque des revendications 1 à 3, dans lequel M est choisi parmi un ion métallique dans lequel le métal correspondant a une valeur d'électronégativité selon Allen inférieure à 2,4.

5. Dispositif électronique organique selon l'une quelconque des revendications 1 à 4, dans lequel M est choisi parmi un métal alcalino-terreux, un métal de transition ou un métal des terres rares, de préférence Cu(II), Ag(I), Zn(II), Fe(II), Fe(III), Mg(II), et plus préférentiellement Cu(II), Ag(I), Zn(II) ou Fe(II).

6. Dispositif électronique organique selon l'une quelconque des revendications 1 à 5, dans lequel M a une masse atomique ≥22 Da.

7. Dispositif électronique organique selon l'une quelconque des revendications 1 à 6, dans lequel l'anion des composés de Formule (1) est choisi parmi A-1 à A-71 :

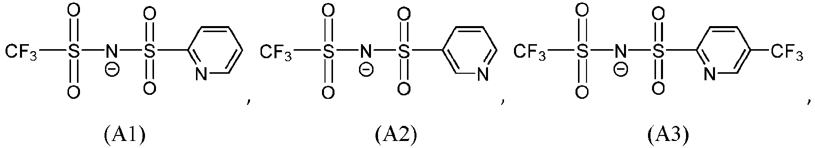

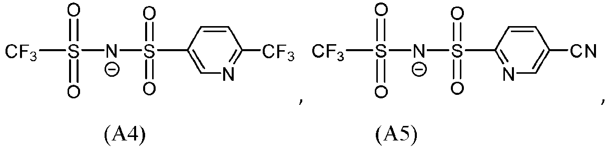

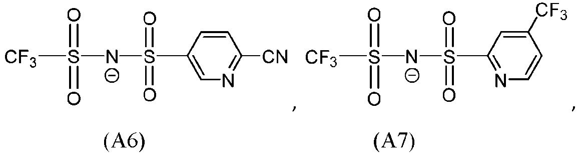

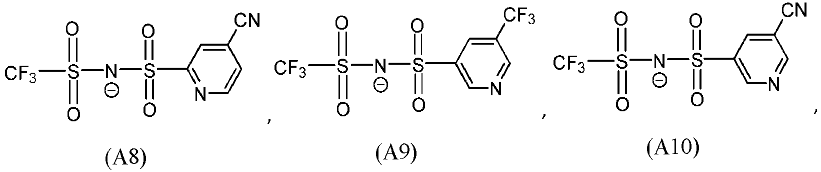

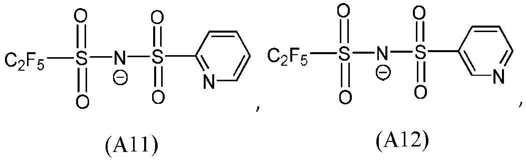

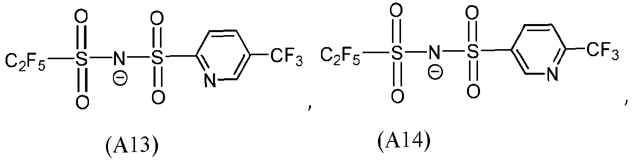

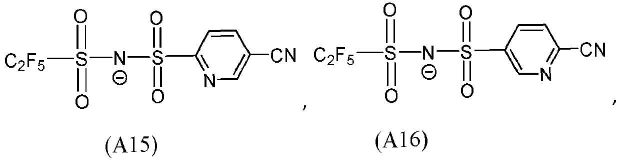

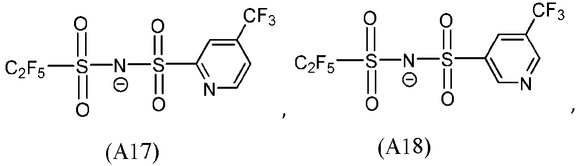

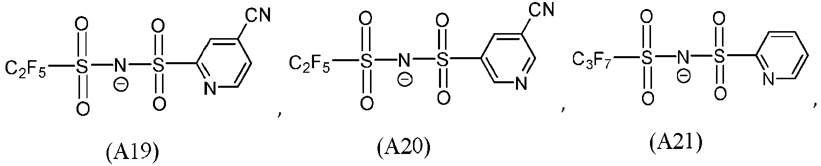

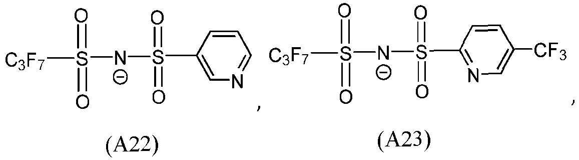

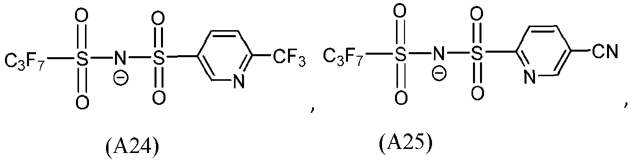

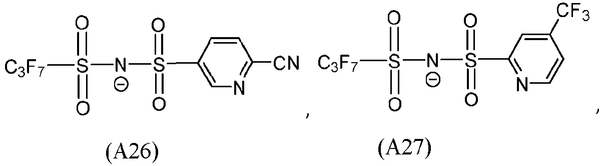

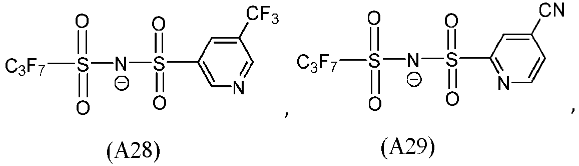

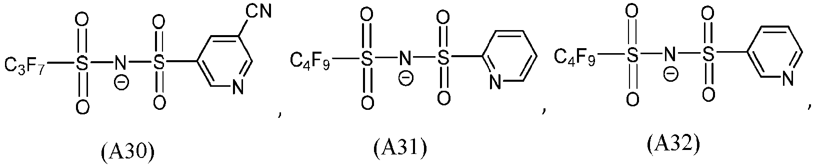

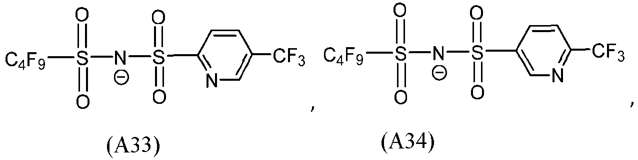

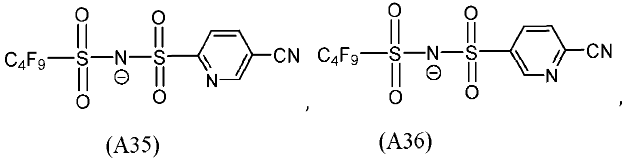

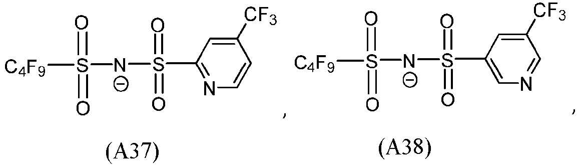

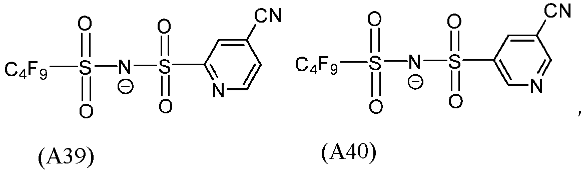

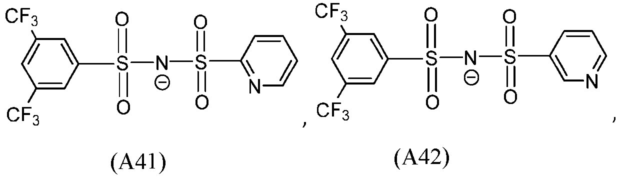

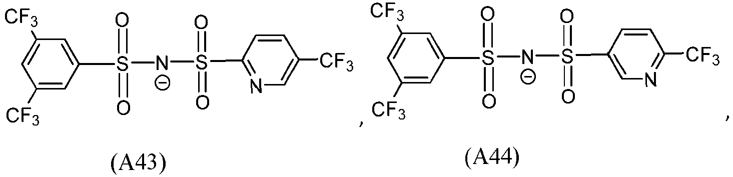

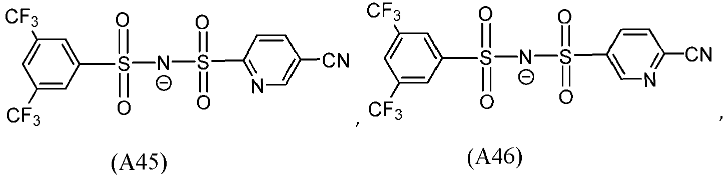

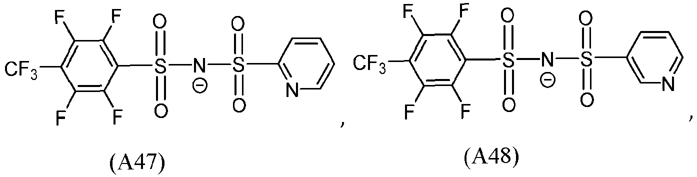

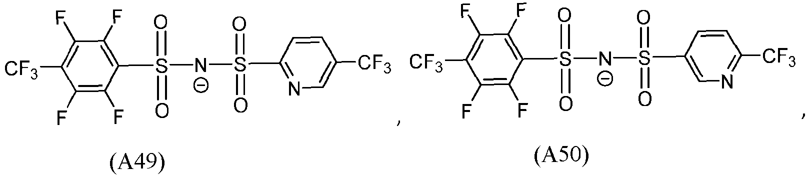

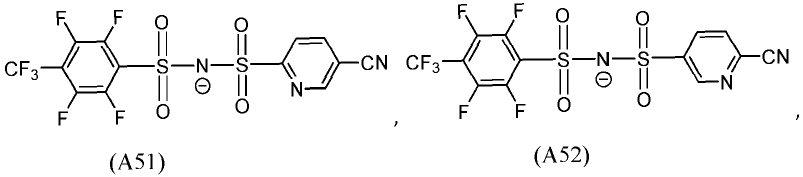

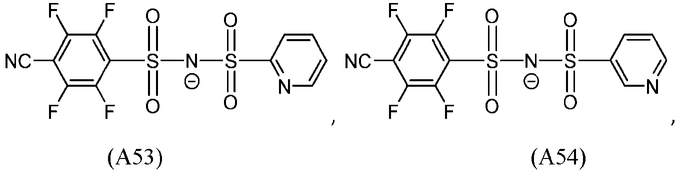

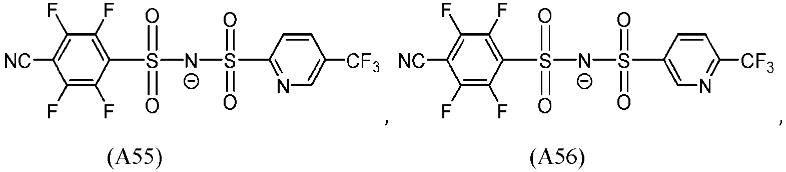

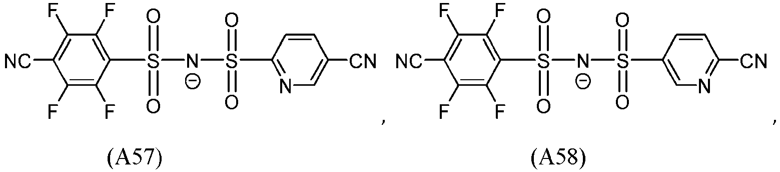

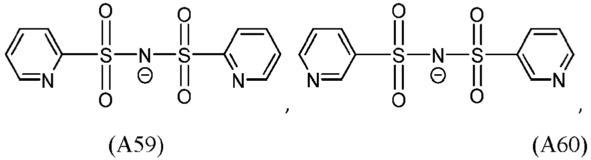

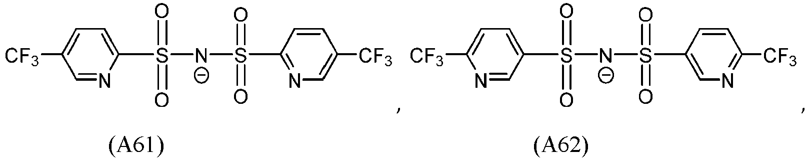

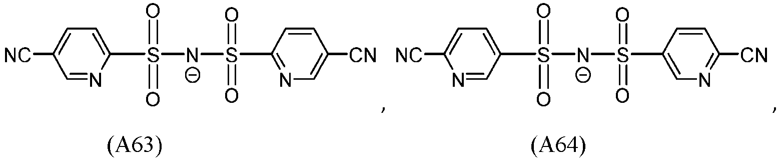

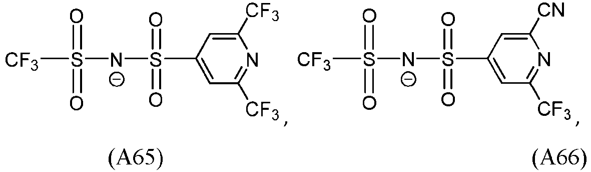

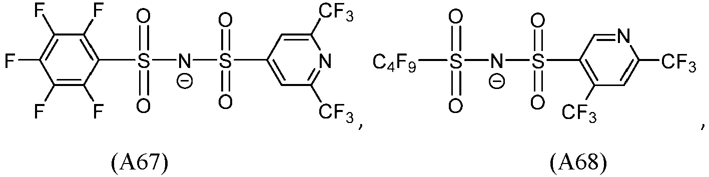

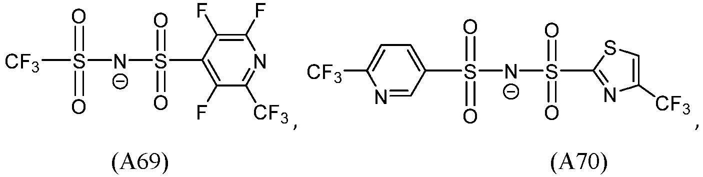

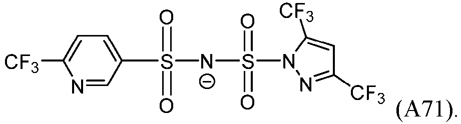

8. Dispositif électronique organique selon l'une quelconque des revendications 1 à 7, dans lequel les composés de Formule (I) sont choisis dans le groupe D1 à D8 :

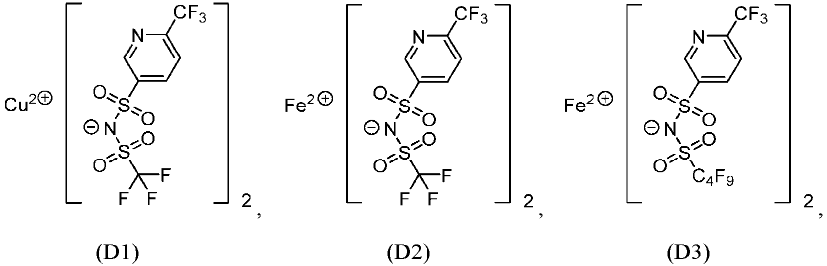

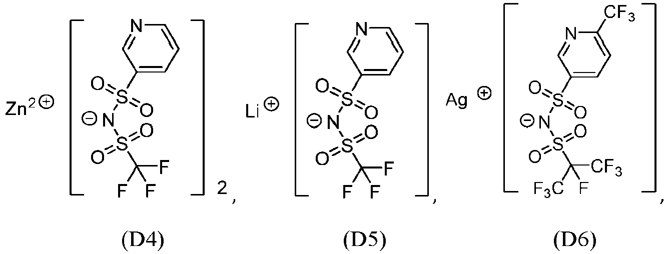

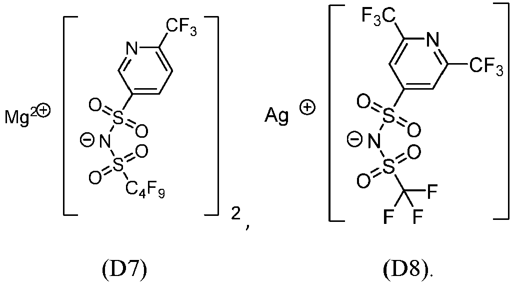

9. Dispositif électronique organique selon l'une quelconque des revendications 1 à 8, dans lequel la au moins une couche de semi-conducteur est une couche de semi-conducteur organique, de préférence une couche d'injection de trous, et de préférence la au moins une couche de semi-conducteur étant non émissive.

10. Dispositif électronique organique selon l'une quelconque des revendications 1 à 9, dans lequel au moins une couche de semi-conducteur comprend en outre un composé matriciel covalent ou un composé matriciel sensiblement covalent, de préférence le composé matriciel covalent ou un composé matriciel sensiblement covalent étant choisi parmi au moins un composé arylamine, un composé diarylamine ou un composé triarylamine.

11. Dispositif électronique organique selon l'une quelconque des revendications 1 à 10, dans lequel le dispositif électronique organique est un dispositif électroluminescent, de préférence une diode émettrice de lumière organique.

12. Dispositif d'affichage comprenant un dispositif électronique organique selon l'une quelconque des revendications 1 à 11.

13. Composé de formule (1) comprenant la Formule (1a) ou (1b) : 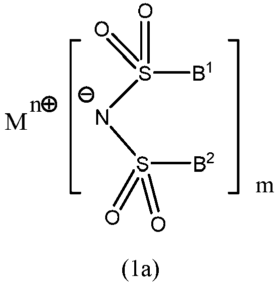
M étant un ion métallique ;
n étant la valence de M ;
m étant n ;
B¹ étant choisi parmi pyridinyle substitué ou non substitué ;
B² étant choisi parmi alkyle en C₁ à C₈, aryle en C₆ à C₁₉ substitué ou non substitué, hétéroaryle en C₂ à C₂₀ substitué ou non substitué, hétérocycle en C₂ à C₂₀ substitué ou non substitué ;
les substituants sur B¹ et B² étant indépendamment choisis parmi D, halogène, Cl, F, CN, alkyle en C₁ à C₈ partiellement ou perfluoré, alcoxy en C₁ à C₈ partiellement ou perfluoré ;
M étant choisi parmi un métal alcalino-terreux, un métal de transition ou un métal des terres rares, de préférence Cu(II), Ag(I), Zn(II), Fe(II), Fe(III), Mg(II), et plus préférentiellement Cu(II), Ag(I), Zn(II) ou Fe(II) ; ou 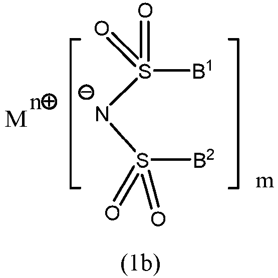
M étant un ion métallique ;
n étant la valence de M ;
m étant n ;
B¹ étant choisi parmi 3-pyridinyle substitué ou non substitué ;
B² étant choisi parmi alkyle en C₁ à C₈ substitué ou non substitué, aryle en C₆ à C₁₉ substitué ou non substitué, hétéroaryle en C₂ à C₂₀ substitué ou non substitué ;
les substituants sur B¹ et B² étant indépendamment choisis parmi D, halogène, Cl, F, CN, alkyle en C₁ à C₈ partiellement ou perfluoré, alcoxy en C₁ à C₈ partiellement ou perfluoré ;
n étant un entier de 1 à 4.
